# FASCICULE DE BREVET EUROPEEN

(11) **EP 3 657 557 B1**
(45) Date de publication et mention de la délivrance du brevet: **07.06.2023**
(21) Numéro de dépôt: 19210242.4
(22) Date de dépôt: 20.11.2019
(51) Int. Cl.: H01L 33/00, H01L 21/02, H01S 5/042, H01S 5/30, H01S 5/02, H01S 5/32

(54) **PROCÉDÉ DE RÉALISATION D'UNE SOURCE DE LUMIÈRE ET SOURCE DE LUMIÈRE**
HERSTELLUNGSVERFAHREN EINER LICHTQUELLE, UND LICHTQUELLE
METHOD FOR MANUFACTURING A LIGHT SOURCE AND LIGHT SOURCE

(30) Priorité: 22.11.2018 FR 1871722
(43) Date de publication de la demande: 27.05.2020
(73) Titulaire: Commissariat à l'Energie Atomique et aux Energies Alternatives, 75015 Paris (FR)
(72) Inventeur: REBOUD, Vincent, 38054 GRENOBLE Cedex 09 (FR); EL ZAMMAR, Georgio, 38054 GRENOBLE CEDEX 09 (FR); KHAZAKA, Rami, 38000 GRENOBLE CEDEX 09 (FR); MENEZO, Sylvie, 38054 GRENOBLE CEDEX 09 (FR)
(74) Mandataire: Hautier IP

(56) Documents cités:
- EP-A1- 0 565 414
- EP-A2- 0 951 055
- US-A1- 2011 227 116
- US-A1- 2018 278 025
- US-B1- 7 603 016

## Description

### DOMAINE TECHNIQUE

L'invention concerne le domaine de la photonique et de l'optoélectronique. Elle trouve au moins une application particulièrement avantageuse dans le domaine des sources de lumière. Elle trouvera pour application avantageuse, mais non limitative, la réalisation de sources à base de germanium émettant dans le spectre du moyen infrarouge (MIR).

### ÉTAT DE LA TECHNIQUE

Dans le domaine de la photonique sur silicium, une source de lumière telle qu'un laser ou une diode électroluminescente est un composant optoélectronique essentiel des systèmes de communication optiques intégrables en technologie CMOS.

Un tel composant comprend une zone active à base d'un matériau à gap direct, permettant d'émettre et/ou d'amplifier la lumière.

Une solution consiste à reporter un ou des matériaux III-V sur le silicium Si. Cette solution met en oeuvre des technologies complexes d'hybridation de matériaux III-V sur Si. En outre cette solution n'est pas pleinement compatible avec les technologies CMOS. Les documents EP 0565414 A1, US 2018/278025 A1, EP 0951055 A2 divulguent en particulier des méthodes de croissance latérale de matériaux III-V sur un substrat à base de silicium. Ces méthodes sont également complexes à mettre en oeuvre.

Une autre solution consiste à épitaxier directement des matériaux à gap direct sur le silicium.

Par exemple, un alliage de germanium-étain GeSn est un matériau compatible avec les technologies CMOS et pouvant présenter un gap direct pour certaines concentrations d'étain et/ou certains états de contraintes mécaniques.

La croissance d'un tel alliage peut se faire à partir d'une couche de germanium Ge s'étendant dans un plan basal sur du silicium. Une telle couche de Ge forme dès lors un substrat virtuel de Ge (Ge-VS) à partir duquel le GeSn est épitaxié.

Le document « Optica Vol. 4, Issue 2, pp. 185-188 (2017) » présente une source de lumière de type LED fabriquée par croissance de GeSn sur Ge-VS.

Un inconvénient de cette solution est l'apparition de dislocations traversantes se propageant verticalement depuis l'interface Ge/GeSn au travers du GeSn.

Ces dislocations traversantes sont des sources de recombinaisons non radiatives. Elles diminuent le rendement d'émission de la source de lumière.

Un autre inconvénient de cette solution est que l'alliage GeSn présente un état de contraintes mécaniques en compression dans le plan basal. US 7 603 016 B1 et US 2011/227116 A1 divulguent d'autres sources de lumière fabriquées par croissance verticale de GeSn ou SiGe sur silicium.

Il est dès lors nécessaire d'augmenter la concentration d'étain pour que le gap de cet alliage conserve un caractère direct.

Par exemple, pour un taux de compression de -0,75% environ, le gap est direct pour une concentration d'étain supérieure ou égale à 13%, tandis que pour un alliage GeSn relâché, une concentration d'étain de 8% à 10% peut suffire à obtenir un gap direct. L'augmentation de la concentration d'étain dans l'alliage induit également des défauts cristallins, sources de recombinaisons non radiatives.

Un objet de la présente invention est de pallier au moins en partie certains des inconvénients mentionnés ci-dessus.

Selon un aspect particulier, un objet de la présente invention est de proposer un procédé de réalisation d'une source de lumière à base de GeSn visant à réduire le taux de dislocations traversantes dans la zone active de la source de lumière.

Selon un autre aspect, un objet de la présente invention est de proposer un procédé de réalisation d'une source de lumière à base de GeSn visant à relâcher les contraintes mécaniques dans la zone active de la source de lumière.

Selon un aspect séparable, un objet de la présente invention est de proposer une source de lumière à base de GeSn présentant une efficacité d'émission améliorée. Les autres objets, caractéristiques et avantages de la présente invention apparaîtront à l'examen de la description suivante et des dessins d'accompagnement. Il est entendu que d'autres avantages peuvent être incorporés. En particulier, certaines caractéristiques et certains avantages du procédé peuvent s'appliquer *mutatis mutandis* à la source de lumière, et réciproquement.

### RÉSUMÉ

Pour atteindre cet objectif, un premier aspect de l'invention concerne un procédé de réalisation d'une source de lumière selon la revendication 1, comprenant une première zone de contact, une deuxième zone de contact et une zone active juxtaposées parallèlement à une première direction d'un plan basal, ladite zone active étant située entre les première et deuxième zones de contact selon une deuxième direction du plan basal.

Ce procédé comprend les étapes suivantes :
fournir un premier substrat comprenant un empilement selon une troisième direction normale au plan basal d'une première couche à base d'un premier matériau sur une deuxième couche à base d'un deuxième matériau différant du premier matériau,
- former, au niveau de la première couche, la première zone de contact,
- former, au niveau de la première couche, la deuxième zone de contact,
- former, au niveau de la première couche, la zone active.

Avantageusement, selon l'invention,
la zone active comprend une couche de base, et cette couche de base est formée par les étapes successives suivantes :
- retirer le premier matériau dans la zone active sur toute l'épaisseur de la première couche de façon à exposer d'une part une portion d'une face inférieure à base du deuxième matériau, et d'autre part au moins une face à base du premier matériau normale au plan basal, dite face latérale de germination, présentant un bord au contact de ladite face inférieure exposée,
- former une couche de germination en un troisième matériau avec une première croissance épitaxiale, dite première croissance latérale, dudit troisième matériau à partir de l'au moins une face latérale de germination, ladite première croissance étant principalement dirigée selon la deuxième direction et au moins partiellement guidée par la portion exposée de la face inférieure, la couche de germination recouvrant uniquement partiellement la portion exposée de la face inférieure de sorte que la couche de germination présente au moins une face à base du troisième matériau normale au plan basal, dite face latérale de base,
- former la couche de base en un quatrième matériau différant du troisième matériau et de préférence à base du troisième matériau, avec une deuxième croissance épitaxiale, dite deuxième croissance latérale, dudit quatrième matériau à partir de l'au moins une face latérale de base, ladite croissance étant principalement dirigée selon la deuxième direction et au moins partiellement guidée par la portion exposée de la face inférieure, de sorte que la couche de base de sorte que la portion exposée de la face inférieure soit entièrement recouverte.

Ce procédé permet d'obtenir une couche de base par croissance latérale, directement au contact du deuxième matériau.

Avantageusement, une telle croissance latérale dirigée selon la deuxième direction permet de limiter la propagation de dislocations traversantes se propageant selon la troisième direction depuis l'interface entre le troisième matériau et le quatrième matériau.

La couche de base en un quatrième matériau présente ainsi un taux de dislocations traversantes réduit. La couche de base en un quatrième matériau présente donc une qualité cristalline optimisée.

Le procédé permet ainsi de réaliser une source de lumière dont la zone active formée à partir d'une telle couche de base présente une qualité cristalline améliorée.

En outre, pour des premier, troisième et quatrième matériaux présentant chacun une structure cristallographique de type cubique, au contact d'un deuxième matériau amorphe, une telle croissance latérale selon une direction de type [010] permet de limiter les contraintes mécaniques dans le plan basal. Le procédé permet ainsi d'obtenir un quatrième matériau relaxé mécaniquement.

La couche de base issue de cette croissance latérale est de préférence de faible épaisseur, par exemple comprise entre 10 nm et 50 nm. Une telle épaisseur de couche de base est avantageusement inférieure à l'épaisseur critique au-delà de laquelle le quatrième matériau relâche par déformation plastique, c'est-à-dire en formant un réseau de dislocations, l'énergie élastique due aux contraintes mécaniques. Une épaisseur de couche de base inférieure à l'épaisseur critique ne présente donc pas de dislocations.

Selon l'invention, le troisième matériau est du germanium (Ge), et le quatrième matériau est un alliage germanium-étain (GeSn) ou de phosphure d'indium (InP).

Le procédé permet avantageusement de réduire les contraintes en compression dans le GeSn ou dans l'InP dans le plan basal.

Le procédé selon l'invention permet de réaliser une source de lumière dans laquelle la zone active comprend une couche de base en GeSn ou en InP présentant une contrainte résiduelle en compression diminuée.

Ce procédé de réalisation d'une source de lumière dont la zone active comprend ou est formée à partir d'une couche de base en GeSn est donc avantageusement compatible avec une réduction de la concentration en Sn dans le GeSn. Il permet en outre d'améliorer la qualité cristalline de la couche de base en GeSn, voire d'éviter l'apparition de dislocations dans la couche de base en GeSn.

La source de lumière issue de ce procédé, par exemple une source cohérente telle qu'un laser ou une source non cohérente telle qu'une LED, présente ainsi une efficacité d'émission améliorée.

En particulier, le seuil d'émission laser peut être abaissé. L'émission laser peut se faire à température ambiante.

Le procédé selon l'invention permet également d'obtenir une couche de base en GeSn directement au contact de la deuxième couche à base du deuxième matériau. Dans le cas d'un deuxième matériau diélectrique, en oxyde de silicium par exemple, une structure de type GeOl (selon l'acronyme anglais « Germanium On Insulator ») est ainsi formée.

La source de lumière issue de ce procédé, par exemple une LED, émet ainsi plus efficacement la lumière. La lumière émise dans la zone active n'est en effet pas piégée par une couche sous-jacente fortement absorbante, telle qu'un substrat virtuel de germanium Ge-VS.

En outre, la disposition relative des zones active et de contact induit une injection latérale des porteurs de charge dans la zone active.

Le procédé selon l'invention permet donc d'obtenir des sources de lumière de type GeOl à injection latérale présentant une qualité cristalline optimisée.

De telles sources de lumière constituent également un aspect séparable de l'invention.

Selon un mode de réalisation préféré de l'invention, une couche de structure dans un matériau à base du matériau de la couche de base, de préférence dans le même matériau que la couche de base, est formée à partir d'une face supérieure de la couche de base.

Cette couche de structure est de préférence formée par une croissance épitaxiale selon la troisième direction, dite croissance verticale.

Une telle couche de structure obtenue par homoépitaxie permet de former, en empilement avec la couche de base, une zone en quatrième matériau présentant une épaisseur plus importante, tout en conservant avantageusement une qualité cristalline du quatrième matériau optimale sur toute l'épaisseur de ladite zone.

Le taux de dislocations traversantes est ainsi réduit à la fois dans la couche de base et dans la couche de structure.

La contrainte en compression dans le plan basal d'une couche de structure en GeSn crue sur une couche de base en GeSn relâchée, est également réduite. La concentration en étain d'une telle couche de structure en GeSn peut ainsi être diminuée tout en conservant la propriété de gap direct pour ce matériau.

Avantageusement, la zone active peut être formée dans l'empilement des couches de base et de structure, par exemple sur toute la hauteur de l'empilement.

La zone active est ainsi formée directement sur la deuxième couche du substrat. Cela permet de confiner efficacement la lumière émise dans la zone active, par exemple selon des modes optiques particuliers de propagation de la lumière.

Un tel confinement est avantageux, par exemple pour une zone active servant de milieu amplificateur.

Selon l'invention, les couches de germination et de base sont crues au sein d'une cavité préalablement formée.

En particulier, selon l'invention, cette cavité comprend l'au moins une face latérale de germination, une paroi inférieure et optionnellement une paroi supérieure. Les parois inférieure et supérieure sont de préférence à base d'un matériau diélectrique pris parmi un oxyde de silicium et un nitrure de silicium. Les première et deuxième croissances latérales principalement dirigées selon la deuxième direction sont dès lors contraintes selon la troisième direction. La formation des couches de germination et de base est ainsi mieux contrôlée. La qualité cristalline des couches de germination et de base est ainsi améliorée.

Le procédé selon l'invention permet en particulier d'obtenir des sources de lumière à base de GeSn présentant une efficacité d'émission et/ou un seuil d'émission améliorés.

Un deuxième aspect séparable de l'invention concerne une source de lumière selon la revendication 12, comprenant une première zone de contact, une deuxième zone de contact et une zone active formées dans une première couche à base d'un premier matériau et juxtaposées de sorte à s'étendre parallèlement suivant une première direction, ladite zone active étant située entre les première et deuxième zones de contact selon une deuxième direction, la première couche étant au contact d'une deuxième couche à base d'un deuxième matériau différant du premier matériau, selon une troisième direction perpendiculaire aux première et deuxième directions.

Avantageusement, et selon l'invention, la source de lumière comprend une couche de germination en un troisième matériau différant des premier et deuxième matériaux et directement au contact du deuxième matériau de la deuxième couche.

La couche de germination est intercalée selon la deuxième direction entre la zone active et l'une au moins parmi les première et deuxième zones de contact.

La zone active est formée suivant une épaisseur de la première couche et comprend un quatrième matériau différant du troisième matériau et de préférence à base du troisième matériau.

Le quatrième matériau est directement au contact du deuxième matériau de la deuxième couche et du troisième matériau de la couche de germination.

Une telle source de lumière permet d'optimiser le confinement optique selon la troisième direction dans la zone active.

Avantageusement, la disposition d'une telle couche de germination intercalée selon la deuxième direction et au contact de la zone active permet de former la zone active à partir d'une croissance épitaxiale du quatrième matériau dirigée selon la deuxième direction.

Une telle croissance permet de limiter l'apparition de dislocations traversantes, c'est-à-dire dirigées selon la troisième direction, au sein de la zone active. Une telle croissance permet également, pour des premier, troisième et quatrième matériaux présentant chacun une structure cristallographique de type cubique, de limiter les contraintes mécaniques dans le plan basal. Dès lors, le quatrième matériau de cette source de lumière est relaxé mécaniquement.

L'épaisseur de la zone active d'une telle source de lumière peut en outre être augmentée par une homoépitaxie du quatrième matériau selon la troisième direction, en conservant avantageusement un taux de dislocations traversantes réduit.

Une telle source de lumière comprend donc avantageusement une zone active présentant à la fois un taux de dislocations réduit, des contraintes résiduelles faibles et une épaisseur importante du quatrième matériau, par exemple sur toute l'épaisseur de la première couche.

Selon l'invention, le premier matériau est du silicium, le deuxième matériau est un matériau diélectrique tel qu'un oxyde de silicium, le troisième matériau est du germanium et le quatrième matériau est un alliage de germanium-étain ou de phosphure d'indium.

Selon l'invention, le quatrième matériau de la source de lumière est à gap direct et est relâché mécaniquement.

La source de lumière selon l'invention peut être réalisée par le procédé selon le premier aspect de l'invention.

### BRÈVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :
Les figures 1 à 18 illustrent des étapes de réalisation d'une source de lumière selon un premier mode de réalisation de la présente invention ;
La figure 19 montre une vue par microscopie électronique en transmission à haute résolution (HRTEM) en coupe transverse d'une couche de germination en Ge selon un mode de réalisation de la présente invention ;

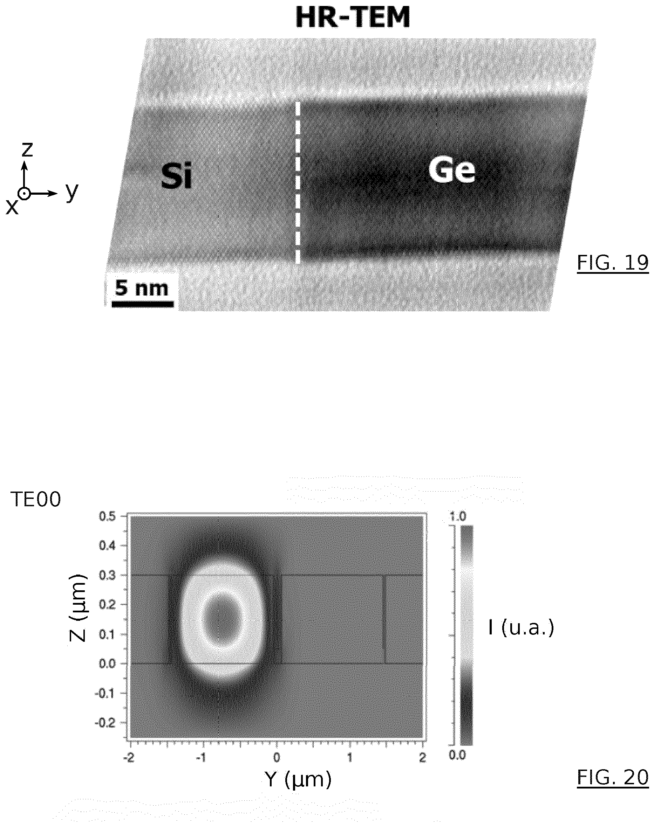

La figure 20 montre un résultat de simulation en coupe transverse d'un mode optique de propagation du flux lumineux dans la zone active d'une source de lumière selon le premier mode de réalisation de la présente invention ; l'intensité lumineuse (u. a.) de ce mode optique TE00 décroît depuis le centre (zone grise correspondant à la zone grise à proximité immédiate de la valeur 1 de l'échelle d'intensité en unité arbitraire (u. a.)) du lobe du mode optique vers la périphérie (zone noire correspondant à la zone noire à proximité immédiate de la valeur 0 de l'échelle d'intensité en unité arbitraire (u. a.)) du lobe du mode optique ;
Les figures 21 à 23 illustrent des étapes de réalisation d'une source de lumière selon un deuxième mode de réalisation de la présente invention ;
Les figures 24 à 26 illustrent des étapes de réalisation d'une source de lumière selon un troisième mode de réalisation de la présente invention ;

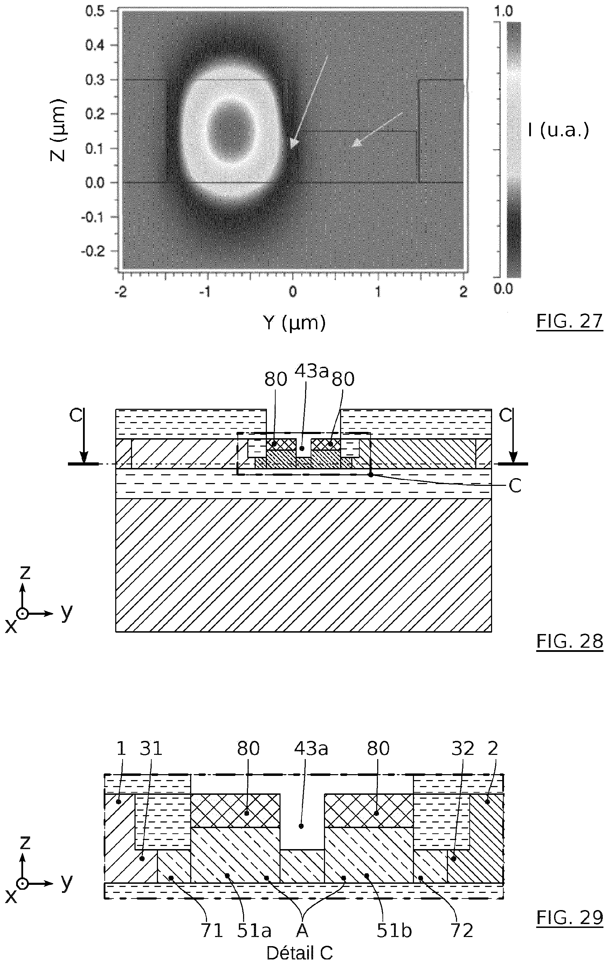

La figure 27 montre un résultat de simulation en coupe transverse d'un mode optique de propagation du flux lumineux dans la zone active d'une source de lumière selon le troisième mode de réalisation de la présente invention ; l'intensité lumineuse (u. a.) de ce mode optique TE00 décroît depuis le centre (zone grise correspondant à la zone grise à proximité immédiate de la valeur 1 de l'échelle d'intensité en unité arbitraire (u. a.)) du lobe du mode optique vers la périphérie (zone noire correspondant à la zone noire à proximité immédiate de la valeur 0 de l'échelle d'intensité en unité arbitraire (u. a.)) du lobe du mode optique ;
Les figures 28 à 30 illustrent des étapes de réalisation d'une source de lumière selon un quatrième mode de réalisation de la présente invention ;

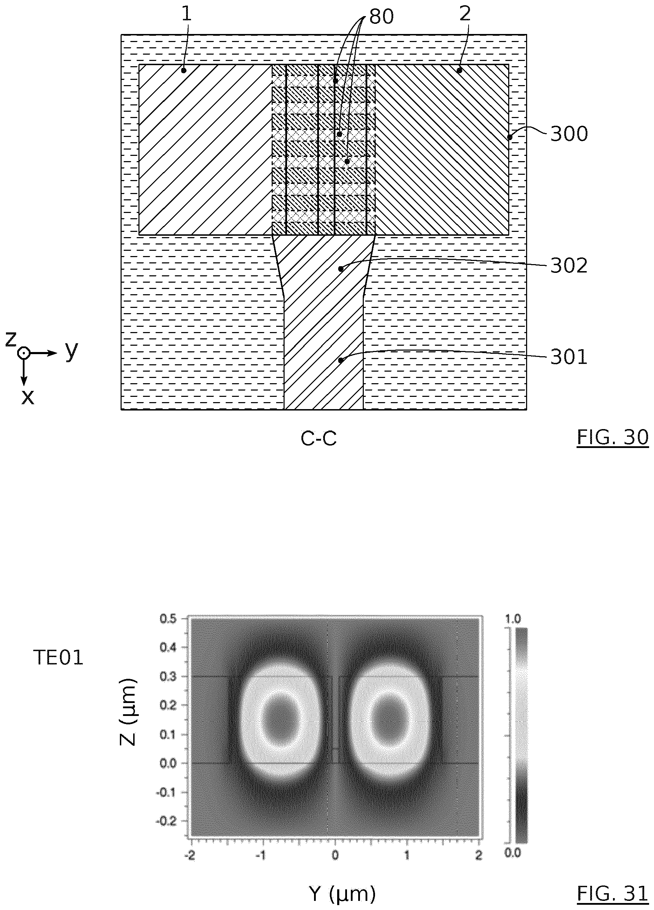

La figure 31 montre un résultat de simulation en coupe transverse d'un mode optique de propagation du flux lumineux dans la zone active d'une source de lumière selon le quatrième mode de réalisation de la présente invention ; l'intensité lumineuse (u. a.) de ce mode optique TE01 décroît depuis le centre (zones grises correspondant à la zone grise à proximité immédiate de la valeur 1 de l'échelle d'intensité en unité arbitraire (u. a.)) de chacun des lobes du mode optique vers la périphérie (zones noires correspondant à la zone noire à proximité immédiate de la valeur 0 de l'échelle d'intensité en unité arbitraire (u. a.)) de chacun des lobes du mode optique ;
La figure 32 montre une source de lumière selon le quatrième mode de réalisation de la présente invention couplée à un convertisseur de modes ;
Les figures 33 à 34 illustrent des étapes de réalisation d'une source de lumière selon un cinquième mode de réalisation de la présente invention.
La figure 35 montre une source de lumière selon un sixième mode de réalisation de la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les épaisseurs et dimensions des différentes couches et portions des sources de lumière illustrées ne sont pas représentatives de la réalité.

### DESCRIPTION DÉTAILLÉE

Avant d'entamer une revue détaillée de modes de réalisation de l'invention, il est rappelé que l'invention selon son premier aspect comprend notamment les caractéristiques ci-après :
Selon un exemple particulier, la zone active A comprend en outre une couche de structure en un cinquième matériau à base du quatrième matériau, ladite couche de structure étant formée avec une croissance épitaxiale, dite croissance verticale, du cinquième matériau selon la troisième direction à partir d'une portion exposée d'une face supérieure 501 de la couche de base 50.
Selon un exemple particulier, le retrait du premier matériau dans la zone active A sur toute l'épaisseur de la première couche comprend les étapes successives suivantes :
   - Retirer le premier matériau de la première couche en conservant une couche sacrificielle 30 à base du premier matériau sur la deuxième couche, ladite couche sacrificielle présentant une épaisseur résiduelle e selon la troisième direction et une largeur w selon la deuxième direction,
   - Encapsuler la couche sacrificielle 30 par une couche d'encapsulation 40 en un matériau d'encapsulation différant du premier matériau,
   - Former au moins une ouverture 41 au travers de la couche d'encapsulation 40 de sorte à exposer une zone de la couche sacrificielle,
   - Former une cavité 42 de largeur ws en retirant le premier matériau sur toute l'épaisseur résiduelle de la couche sacrificielle (30) au travers de l'au moins une ouverture 41, de façon à exposer la face inférieure 424 à base du deuxième matériau, l'au moins une face latérale de germination 421 et une face 423 de la couche d'encapsulation, la cavité 42 comprenant ladite au moins une face latérale de germination 421, une paroi inférieure formée par ladite face inférieure 424 et une paroi supérieure parallèle au plan basal et à base du matériau d'encapsulation formée par ladite face 423 de la couche d'encapsulation 40,
   de sorte que la première croissance latérale permettant de former la couche de germination et la deuxième croissance latérale permettant de former la couche de base 50 soient au moins partiellement guidées par lesdites parois inférieure et supérieure, la couche de germination et la couche de base 50 présentant des épaisseurs égales à l'épaisseur résiduelle e.
Selon un exemple particulier, la formation de l'au moins une ouverture est configurée de sorte à ce que la zone exposée de la couche sacrificielle 30 soit située en dehors de la zone active A, de préférence à une distance supérieure à 1 µm de la zone active.
Selon un exemple particulier, l'au moins une ouverture 41 présente un contour fermé et est distante de l'une au moins parmi les première et deuxième zones de contact 1, 2 d'une distance d selon la deuxième direction y telle que 0.6 µm < d < 1.5 µm et de préférence 1.1 µm < d < 1.5 µm.
Selon un exemple particulier, l'au moins une ouverture est située selon la deuxième direction à égale distance des première et deuxième zones de contact 1, 2.
Selon un exemple particulier, la formation de la couche de structure comprend en outre, avant la croissance verticale, l'étape suivante :
   Former au moins une couche latérale 61, 62 présentant des parois latérales sensiblement normales au plan basal en un matériau différant du premier matériau, ladite au moins une couche latérale 61, 62 prenant appui sur une face parallèle au plan basal comprenant la face supérieure (501) de la couche de base 50,
   de sorte que la croissance verticale permettant de former la couche de structure 51 soit au moins partiellement guidée par lesdites parois latérales.
Selon un exemple particulier, le procédé comprend les sous-étapes suivantes avant formation de l'au moins une couche latérale 61, 62 :
   Retirer partiellement la couche d'encapsulation 40 de façon à exposer partiellement une face parallèle au plan basal comprenant la face supérieure 501 de la couche de base 50, en laissant une partie du matériau d'encapsulation de façon à former l'au moins une couche latérale 61, 62.
Selon un exemple particulier, le procédé comprend les sous-étapes suivantes avant formation de l'au moins une couche latérale :
   Retirer totalement la couche d'encapsulation 40 de façon à exposer une face parallèle au plan basal comprenant la face supérieure 501 de la couche de base 50,
   Former au moins une couche latérale en un matériau pris parmi un oxyde de silicium ou un nitrure de silicium.
Selon un exemple particulier, l'au moins une couche latérale 61, 62 présente une largeur w1, w2 selon la deuxième direction supérieure ou égale à 10 nm et/ou inférieure ou égale à 100 nm.
Selon un exemple particulier, les premier, troisième et quatrième matériaux présentent chacun une structure cristallographique de type cubique.
Selon un exemple particulier, la première direction correspond à une orientation cristallographique de type [100], la deuxième direction correspond à une orientation cristallographique de type [010], et la troisième direction correspond à une orientation cristallographique de type [001].
Selon un exemple particulier, le retrait du premier matériau lors de la formation de la cavité se fait par gravure, ladite gravure étant configurée pour produire une vitesse de gravure au moins 25 % plus grande dans des directions cristallographiques [110] et [1-10] que dans des directions cristallographiques [010] et [100] du premier matériau de la première couche, et de préférence au moins 35 % plus grande.
Selon un exemple particulier, la largeur ws de la cavité est inférieure à la largeur w de la couche sacrificielle, de sorte que la couche sacrificielle 30 forme au moins une marche 31 entre la deuxième couche (2 et la première couche 11.
Selon un exemple particulier, la couche de germination présente une épaisseur égale à l'épaisseur de la marche 31.
Selon un exemple particulier, la couche de base 50 présente une épaisseur égale à l'épaisseur de la couche de germination.
Selon un exemple particulier, la couche de base 50 présente une épaisseur supérieure ou égale à 10 nm et/ou inférieure ou égale à 50 nm.
Selon un exemple particulier, la couche de germination présente une largeur supérieure ou égale à 10 nm et/ou inférieure ou égale à 100 nm.
Selon un exemple particulier, la couche de germination présente une épaisseur supérieure ou égale à 10 nm et/ou inférieure ou égale à 50 nm.
Selon un exemple particulier, la deuxième croissance latérale présente un premier front de croissance à partir d'une première face latérale de base et un deuxième front de croissance à partir d'une deuxième face latérale de base, lesdits premier et deuxième front de croissance se rejoignant au niveau d'une zone de jonction pour former la couche de base, et dans lequel la couche de base 50 comprend ladite zone de jonction.
Selon un exemple particulier, la couche de base 50 est partiellement gravée selon la troisième direction au niveau de la zone de jonction.
Selon un exemple particulier, la couche de structure est partiellement gravée selon la troisième direction au niveau d'une zone en prolongement de la zone de jonction.
Selon un exemple particulier, le procédé comprend en outre une formation au niveau de la première couche d'un guide d'onde en couplage direct avec la zone active.
Selon un exemple particulier, le procédé comprend en outre une formation d'un guide d'onde en couplage évanescent avec la zone active A.
Selon un exemple particulier, le premier substrat 101 comprend une troisième couche 13, de sorte que la deuxième couche 12 soit intercalée entre les première et troisième couches 11, 13 selon la troisième direction z, et le procédé comprend en outre une séquence d'étapes de retournement de la source de lumière sur un deuxième substrat 102, ladite séquence comprenant les étapes suivantes :
   fournir un deuxième substrat 102,
   coller par adhésion moléculaire le deuxième substrat 102 au premier substrat 101 selon la troisième direction z, la première couche 11 du premier substrat 101 étant tournée en regard du deuxième substrat 102,
   retirer la troisième couche 13 du premier substrat 101,
   former au travers de la deuxième couche du premier substrat des premier et deuxième contacts métalliques respectivement sur les première et deuxième zones de contact.
Selon un exemple particulier, la première croissance latérale permettant de former la couche de germination se fait au moins en partie à une première température T1 comprise entre 400°C et 450°C.
Selon un exemple particulier, la première croissance latérale permettant de former la couche de germination se fait à une température comprise entre 400°C et 600°C, et au moins en partie à la première température T1 dite température basse comprise entre 400°C < T1 < 450°C.
Selon un exemple particulier, la deuxième croissance latérale permettant de former la couche de base 50 se fait à une deuxième température T2 comprise entre 300°C et 400°C.
Selon un exemple particulier, la deuxième croissance latérale permettant de former la couche de base se fait à une température comprise entre 300°C et 700°C, et au moins en partie à la deuxième température T2 comprise entre 300°C et 400°C.
Selon un exemple particulier, la croissance verticale permettant de former la couche de structure se fait à la deuxième température T2 comprise entre 300°C et 400°C.
Selon un exemple particulier, la croissance verticale permettant de former la couche de structure se fait à une température comprise entre 300°C et 700°C, et au moins en partie à la deuxième température T2 comprise entre 300°C et 400°C.
Selon un exemple particulier, le procédé comprend en outre une étape de formation de réflecteurs de Bragg distribués dans une partie supérieure de la zone active A.
Selon un exemple particulier, le procédé comprend, après formation de la zone active A, une étape de structuration d'une surface de la zone active, ladite surface structurée étant configurée pour optimiser une extraction de la lumière émise, en dehors de la zone active.
Le premier matériau est du silicium ou du silicium-germanium, le deuxième matériau est un matériau diélectrique, le troisième matériau est du germanium et le quatrième matériau est un alliage de germanium-étain GeSn ou de phosphure d'indium, ou un matériau III-V.

L'invention selon son deuxième aspect comprend notamment les caractéristiques ci-après :
Selon un exemple particulier, l'une au moins parmi les première et deuxième zones de contact 1, 2 présente une marche en regard de l'autre parmi les première et deuxième zones de contact, ladite marche prenant appui sur la deuxième couche 12 et étant située entre la première couche 11 et la zone active A.
Selon un exemple particulier, la marche est située entre la première couche 11 et la couche de germination.
Selon un exemple particulier, la marche présente une épaisseur e selon la troisième direction supérieure ou égale à 10 nm et/ou inférieure ou égale à 50 nm.
Selon un exemple particulier, la marche présente une largeur w1, w2 selon la deuxième direction supérieure ou égale à 10 nm et/ou inférieure ou égale à 100 nm.
Selon un exemple particulier, la marche présente une épaisseur inférieure à celle de la zone active A.
Selon un exemple particulier, la marche présente une épaisseur inférieure à celle d'une portion principale de l'une au moins parmi les première et deuxième zones de contact portant la marche.
Selon un exemple particulier, la marche présente une épaisseur sensiblement égale à l'épaisseur de la couche de germination.
Selon un exemple particulier, la source de lumière comprend en outre au moins une couche latérale prenant appui sur la marche et située entre la première couche et la zone active, ladite au moins une couche latérale étant en un matériau pris parmi un oxyde de silicium et un nitrure de silicium.
Selon un exemple particulier, la couche de germination présente une épaisseur supérieure ou égale à 10 nm et/ou inférieure ou égale à 50 nm.
Le premier matériau est du silicium ou du silicium-germanium, le deuxième matériau est un matériau diélectrique tel qu'un oxyde de silicium, le troisième matériau est du germanium et le quatrième matériau est un alliage de germanium-étain GeSn ou de phosphure d'indium InP.
Le quatrième matériau est à gap direct.

Le quatrième matériau est relaxé mécaniquement. Un tel quatrième matériau relaxé mécaniquement est avantageusement obtenu par le procédé selon le premier aspect de l'invention.

Selon un exemple particulier, le contraste d'indice entre les deuxième et quatrième matériaux est supérieur au contraste d'indice entre les premier et quatrième matériaux.
Selon un exemple particulier, la zone active A comprend un cinquième matériau à base du quatrième matériau formant un empilement selon une troisième direction z avec ledit quatrième matériau.
Selon un exemple particulier, la zone active A est configurée pour émettre un flux lumineux se propageant principalement selon la première direction x selon un mode optique de propagation de type TE01, dit mode TE01.
Selon un exemple particulier, la source de lumière comprend en outre un convertisseur de mode 302, 301, 400 directement couplé à la zone active A, ledit convertisseur de mode 302, 301, 400 étant configuré pour convertir ledit mode TE01 en un mode optique de propagation de type TE00, dit mode TE00, de préférence avec une efficacité de conversion supérieure ou égale à 95%, et de préférence avec une efficacité de conversion supérieure ou égale à 97%.

Dans la suite, une zone active est une zone configurée pour émettre des photons. Ces photons peuvent être générés directement par recombinaison de porteurs de charges électriques injectés au niveau de la zone active, ou par émission stimulée. La zone active est de préférence en germanium-étain ou en phosphure d'indium dans la présente demande. Elle peut faire office de milieu amplificateur pompé électriquement.

Dans la présente invention des modes de guidage d'un flux lumineux ou d'une onde lumineuse seront indiqués. Une onde lumineuse est une onde électromagnétique comportant un champ électrique oscillant couplé à un champ magnétique oscillant. Lorsque l'onde lumineuse est confinée dans un guide d'onde ou une cavité optique par exemple, elle se propage suivant différents modes dits transverses (à cause des conditions aux limites imposées par le confinement) parmi lesquels :
- les modes TE (Transverse Electric selon l'acronyme anglais) ne présentant pas de champ électrique selon la direction de propagation. Le mode fondamental correspondant est noté TE00, les modes secondaires correspondants sont notés TE01, TE10, TE11, TE02, TE12 etc.
- les modes TM (Transverse Magnetic selon l'acronyme anglais) ne présentant pas de champ magnétique selon la direction de propagation. Le mode fondamental correspondant est noté TM00, les modes secondaires correspondants sont notés TM01, TM 10, TM11, TM02, TM 12 etc.

Il est précisé que, dans le cadre de la présente invention, la disposition relative d'une troisième zone intercalée entre une première zone et une deuxième zone, ne signifie pas obligatoirement que les zones sont directement au contact les unes des autres, mais signifie que la première zone est soit directement au contact des première et deuxième zones, soit séparée de celles-ci par au moins une autre zone ou au moins un autre élément.

Les étapes de formation des zones, notamment les zones actives, de contact et d'injection, s'entendent au sens large : elles peuvent être réalisées en plusieurs sous-étapes qui ne sont pas forcément strictement successives.

Dans la présente invention des types de dopage sont indiqués. Ces dopages sont des exemples non limitatifs. L'invention couvre tous les modes de réalisation dans lesquels les dopages sont inversés. Ainsi, si un exemple de réalisation mentionne pour une première zone un dopage p et pour une deuxième zone un dopage n, la présente description décrit alors, implicitement au moins, l'exemple inverse dans lequel la première zone présente un dopage n et la deuxième zone un dopage p.

Les gammes de dopage associées aux différents types de dopage indiqués dans la présente demande sont les suivantes :
dopage p++ ou n++ : supérieur à 1 × 10²⁰cm⁻³
dopage p+ ou n+ : 1 × 10¹⁸ cm⁻³ à 9 × 10¹⁹ cm⁻³
dopage p ou n : 1 × 10¹⁷ cm⁻³ à 1 × 10¹⁸ cm⁻³
dopage intrinsèque : 1.10¹⁵ cm⁻³ à 1.10¹⁷ cm⁻³

Dans la suite, les abréviations suivantes relatives à un matériau M sont éventuellement utilisées :
M-i réfère au matériau M intrinsèque ou non intentionnellement dopé, selon la terminologie habituellement utilisée dans le domaine de la microélectronique pour le suffixe -i.
M-n réfère au matériau M dopé n, n+ ou n++, selon la terminologie habituellement utilisée dans le domaine de la microélectronique pour le suffixe -n.
M-p réfère au matériau M dopé p, p+ ou p++, selon la terminologie habituellement utilisée dans le domaine de la microélectronique pour le suffixe -p.

On entend par un substrat, un film, une couche, « à base » d'un matériau M, un substrat, un film, une couche comprenant ce matériau M uniquement ou ce matériau M et éventuellement d'autres matériaux, par exemple des éléments d'alliage, des impuretés ou des éléments dopants. Ainsi, une couche en un matériau à base de germanium (Ge) peut par exemple être une couche de germanium (Ge ou Ge-i) ou une couche de germanium dopé (Ge-p, Ge-n) ou encore une couche d'un alliage de germanium-étain (GeSn). Une couche en un matériau à base de silicium (Si) peut par exemple être une couche de silicium (Si ou Si-i) ou une couche de silicium dopé (Si-p, Si-n).

Dans la présente demande de brevet, les première, deuxième et troisième directions correspondent respectivement aux directions portées par les axes x, y, z d'un repère de préférence orthonormé. Ce repère est représenté sur les figures annexées à la présente demande de brevet.

Dans la suite, la longueur est prise selon la première direction x, la largeur est prise selon la deuxième direction y, et l'épaisseur est prise selon la troisième direction z.

Dans la suite, un matériau relaxé mécaniquement signifie que ce matériau présente une valeur de contraintes résiduelles inférieure à 200 MPa, et de préférence inférieure à 50 MPa.

Dans la suite, les faces ou les flancs sont décrits, par souci de clarté, tels que s'étendant principalement selon des plans. Ces faces et ces flancs ne sont cependant pas rigoureusement compris dans lesdits plans, en tenant compte des tolérances de fabrication et/ou de mesure. Ces faces et ces flancs peuvent présenter des courbures et/ou des déviations angulaires en dehors desdits plans. La projection d'une face ou d'un flanc dans le plan correspondant présente néanmoins de préférence une surface supérieure ou égale à 80% de la surface de la face ou du flanc. Une orientation normale à un plan, notamment normale au plan basale, s'entend comme adoptant la tolérance géométrique indiquée ci-dessus ; en particulier, la face latérale de germination et la face latérale de base peuvent ne pas être rigoureusement « verticales » mais être inclinées et/ou non planes, dans une mesure qui autorise malgré tout les fonctions de support de croissance latérale décrites.

On entend par « latérale » selon les cas : une orientation des parois ou des couches normale à y, une croissance par épitaxie dirigée selon y, une disposition selon y des différentes zones ou éléments de la source de lumière relativement les uns aux autres.

Pour déterminer la géométrie des interfaces entre les différentes couches, en particulier entre la couche sacrificielle et la couche de germination, et entre la couche de germination et la couche de base, on peut procéder à des analyses de Microscopie Electronique à Balayage (MEB) ou de Microscopie Electronique en Transmission (MET ou TEM pour l'acronyme anglais de « Transmission Electron Microscopy »).

Une croissance épitaxiale d'un matériau sur un autre produit une interface bien définie et sensiblement plane entre ces matériaux. En particulier, une croissance épitaxiale latérale de Ge sur une face latérale de Si produit une interface Si-Ge plane et potentiellement sans défauts structuraux. Une telle interface Si-Ge obtenue par le procédé selon l'invention est illustrée à la figure 19 annexée à la présente demande.

Ces techniques permettent également d'observer la présence d'une marche prenant appui sur la deuxième couche et étant située entre la première couche et la zone active d'une source de lumière selon l'invention.

Les compositions chimiques des différentes zones peuvent être déterminées à l'aide des méthodes suivantes bien connues telles que :
- EDX ou X-EDS acronyme de « energy dispersive x-ray spectroscopy » qui signifie « analyse dispersive en énergie de photons X ».

Cette méthode est bien adaptée pour analyser la composition de dispositifs de petites tailles tels que des sources de lumière comprenant des couches ou des zones de faibles épaisseurs. Elle peut être mise en oeuvre sur des coupes métallurgiques au sein d'un Microscope Electronique à Balayage (MEB) ou sur des lames minces au sein d'un Microscope Electronique en Transmission (MET).
- SIMS, acronyme de « Secondary Ion Mass Spectroscopy » qui signifie « Spectroscopie de Masse à Ionisation Secondaire ».
- ToF-SIMS, acronyme de « Time of Flight Secondary Ion Mass Spectroscopy » qui signifie « Spectroscopie de Masse à Ionisation Secondaire à temps de vol ».

Ces méthodes permettent d'accéder à la composition élémentaire des zones.

La qualité structurale d'une couche peut être étudiée par Microscopie Electronique en Transmission (MET ou TEM pour l'acronyme anglais de « Transmission Electron Microscopy »).

Les dislocations traversantes peuvent être en particulier observées par cette technique et ses dérivés (observation en faisceau faible et/ou champ sombre par exemple).

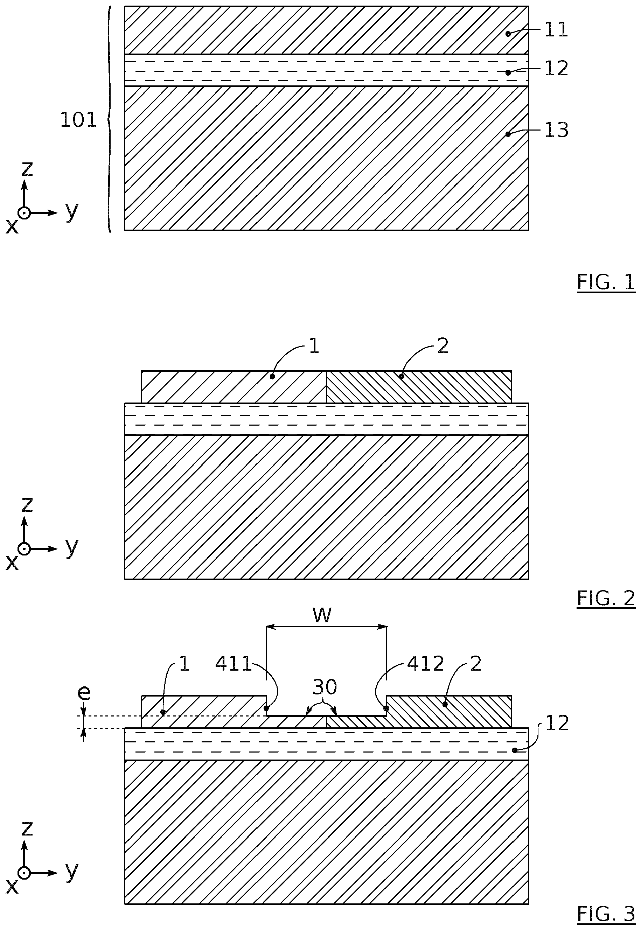

Un premier mode de réalisation du procédé selon l'invention va maintenant être décrit en référence aux figures 1 à 18. La source de lumière obtenue par ce premier mode de réalisation est un une source laser GeSn sur isolant à injection latérale comprenant une zone active A en GeSn-i intercalée selon y entre une première zone de contact 1 en Si-p et une deuxième zone de contact 2 en Si-n.

Avantageusement, la zone active est obtenue par trois croissances épitaxiales successives. Une première croissance épitaxiale latérale de Ge permet notamment de former une couche de germination. Une deuxième croissance épitaxiale latérale de GeSn permet de former une couche de base à partir de la couche de germination. Cette deuxième croissance épitaxiale latérale est suivie d'une croissance épitaxiale verticale de GeSn de façon à former une couche de structure sur la couche de base.

Selon le premier mode de réalisation, une première étape consiste à fournir un substrat 101 (figure 1) de préférence SOI (acronyme de « Silicon On Insulator » signifiant silicium sur isolant ; mais des matériaux autres que le silicium sont aussi possibles). La première couche 11 en silicium, également dénommée top Si (signifiant silicium supérieur) dans la suite, présente de préférence une épaisseur comprise entre 100 nm et 700 nm, de préférence sensiblement égale à 300 nm. La deuxième couche 12 en dioxyde de silicium, également dénommée BOX (acronyme de « Burried Oxide » signifiant oxyde enterré) présente une épaisseur comprise entre 10 nm et 3µm, de préférence comprise entre 10 nm et 100 nm, de préférence sensiblement égale à 20 nm. La troisième couche 13 est en silicium et peut être également dénommée Si bulk (signifiant silicium massif) dans la suite.

Ce substrat peut présenter un diamètre de 200 mm ou 300 mm.

L'étape suivante consiste à former au niveau de la première couche 11 les première et deuxième zones de contact 1, 2, de préférence par implantation ionique sur toute l'épaisseur du top Si 11 (figure 2). La première zone de contact 1 peut être dopée p+ et présenter une concentration de dopants comprise entre 1 à 3 × 10¹⁹ cm⁻³. Elle peut présenter une largeur de l'ordre de 15 µm ou plus.

La deuxième zone de contact 2 peut être dopée n+ et présenter une concentration de dopants comprise entre 1 à 3 × 10¹⁹ cm⁻³. Elle peut présenter une largeur de l'ordre de 15 µm ou plus.

Les première et deuxième zones de contact 1, 2 peuvent être adjacentes selon un plan zx.

Une étape de définition d'un premier motif 300 comprenant la première zone de contact 1, la zone active A et la deuxième zone de contact 2 est de préférence effectuée par lithographie et gravure sélective du top Si sur toute sa hauteur (figure 2). La gravure sélective du top Si 11 par rapport au BOX 12 en dioxyde de silicium est largement connue et n'est pas caractéristique de la présente invention.

La définition d'un deuxième motif en forme de guide d'onde peut également être effectuée par lithographie et gravure sélective du top Si sur toute sa hauteur, de préférence lors de la définition du premier motif 300.

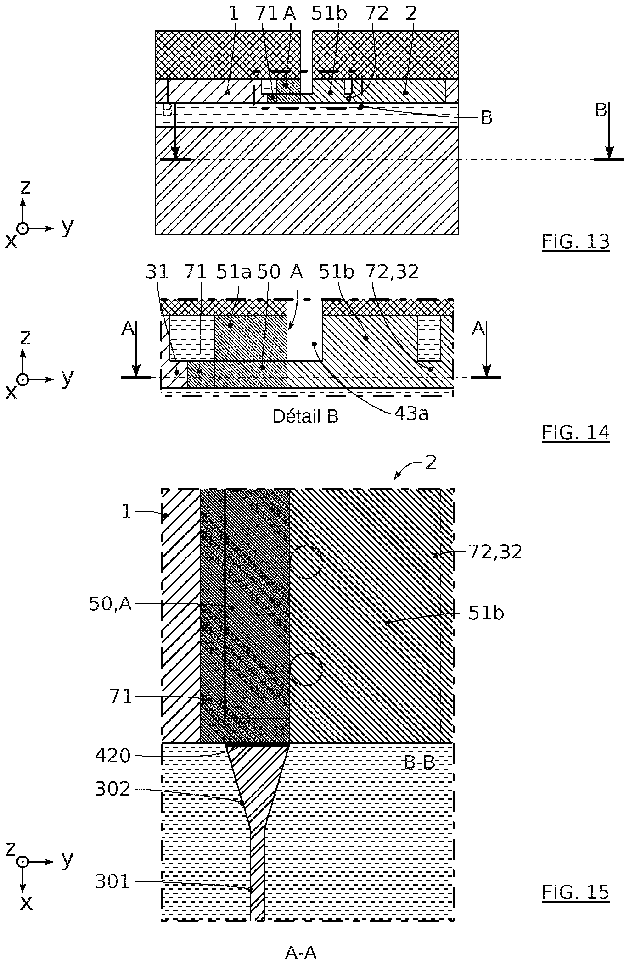

Ce guide d'onde 301 est de préférence configuré pour coopérer avec la zone active A par couplage direct (figure 15). Le guide d'onde 301 présente de préférence une continuité avec la zone active A du premier motif 300, par exemple par l'intermédiaire d'un connecteur tronconique appelé fuseau 302.

Le guide d'onde 301 peut être centré ou non sur la zone active A. Il peut présenter une largeur comprise entre 300 nm et 600 nm, de préférence de l'ordre de 400 nm. Sa hauteur peut être égale à celle du top Si 11.

Le fuseau 302 peut être configuré pour collecter la lumière émise dans la zone active A et la transmettre dans le guide d'onde 301. Il permet en particulier de connecter et/ou coupler optiquement une zone active A à un guide d'onde 301, dans le cas où la zone active A présente une largeur supérieure à celle du guide d'onde 301. De tels fuseaux 302 sont couramment utilisés dans les systèmes de communication optique sur Si et sont largement connus.

Une première ouverture est réalisée par lithographie et gravure dans le top Si 11 sur une partie de sa hauteur, dite partie supérieure (figure 3).

Cette première ouverture est réalisée entre les première et deuxième zones de contact 1, 2, et aussi de préférence en partie dans les première et deuxième zones de contact 1, 2. Elle est située pour partie en sortie du fuseau 302 ou guide d'onde 301.

Elle comprend des première et deuxième faces latérales 411, 412 selon zx, et une face de sortie selon zy. Ces faces sont également dénommées simplement flancs.

Cette première ouverture présente de préférence une largeur w entre les première et deuxième faces latérales 411, 412 comprise entre 1 µm et 4 µm, par exemple de l'ordre de 3,2 µm.

Elle présente de préférence une longueur sensiblement égale ou légèrement supérieure à la longueur des première et deuxième zones de contact 1, 2, de façon à séparer lesdites première et deuxième zones de contact 1, 2 sur la partie supérieure.

Cette première ouverture permet d'exposer une couche sacrificielle 30 au contact du BOX 12, en partie inférieure du top Si 11, sans exposer la couche sous-jacente, ici la couche BOX 12.

La gravure du top Si 11 est connue en soi. Elle est configurée pour être arrêtée dans le top Si 11 de façon à former une couche sacrificielle 30 présentant une épaisseur résiduelle e de préférence inférieure ou égale à 50 nm, voire à 20 nm et /ou supérieure ou égale à 10 nm (figure 3).

Cette couche sacrificielle 30 de largeur w et d'épaisseur e comprend une partie des première et deuxième zones de contact 1, 2 dans la partie inférieure. Elle assure une continuité entre les première et deuxième zones de contact 1, 2, et éventuellement une continuité avec le guide d'onde 301.

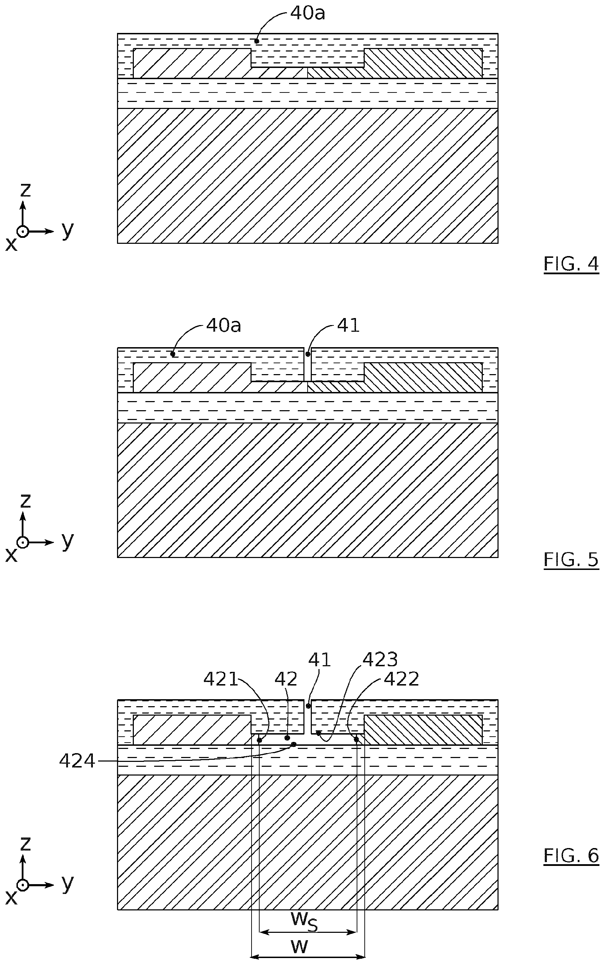

Une étape d'encapsulation est ensuite effectuée de sorte à recouvrir les premier et deuxième motifs 300, 301 par une couche d'encapsulation 40a, et en particulier de façon à couvrir le fond et les flancs à base de Si de la première ouverture (figure 4). La couche d'encapsulation 40a peut remplir la première ouverture.

La couche d'encapsulation 40a peut être déposée par une méthode de dépôt chimique en phase vapeur (CVD). La couche d'encapsulation 40a présente de préférence une épaisseur comprise entre 100 nm et 300 nm. Elle peut être une couche d'oxyde, par exemple une couche de dioxyde de silicium.

Un polissage mécano-chimique CMP (signifiant « Chemical-Mechanical Polishing selon l'acronyme anglais) peut être effectué de manière à planariser la couche d'encapsulation 40a pour obtenir une surface plane dans un plan xy. Ce polissage CMP est configuré pour laisser une épaisseur de couche d'encapsulation 40a comprise entre 50nm et 200nm, de sorte à protéger les premier et deuxième motifs 300, 301 notamment lors des étapes suivantes de gravure.

Après encapsulation et éventuellement après CMP, une ou des ouvertures 41 sont formées au travers de la couche d'encapsulation 40a selon toute son épaisseur de sorte à exposer des zones de la couche sacrificielle 30 (figure 5). Ces ouvertures 41 peuvent être formées à l'issue d'étapes classiques de lithographie/gravure. Les ouvertures 41 présentent de préférence une section circulaire ayant un diamètre compris entre 50 nm et 200 nm, de préférence de l'ordre de 100 nm. Plus généralement, la plus grande dimension en section dans le plan xy des ouvertures 41 est de préférence inférieure ou égale à 200 nm et/ou supérieure ou égale à 50 nm.

Ces ouvertures 41 sont de préférence situées à une distance d selon y de la première zone de contact 1 et/ou de la deuxième zone de contact 2, telle que 0.6 µm < d ≤ 1.5 µm et de préférence d ≈ 1,5 µm. Cela permet d'éloigner les ouvertures 41 de la première zone de contact 1 et/ou de la deuxième zone de contact 2. Les ouvertures constituent en effet des singularités qui peuvent engendrer certains aléas lors des étapes suivantes de procédé, en particulier lors de l'épitaxie latérale de GeSn dans la cavité 42 formée par retrait au moins partiel de la couche sacrificielle 30. Dès lors, il est avantageux de former les ouvertures 41 le plus loin possible de la première zone de contact 1 et/ou de la deuxième zone de contact 2 et/ou de la zone active A, de manière à ce que le passage des charges électriques et/ou du flux lumineux ne soit pas perturbé par les singularités formées par ces ouvertures 41.

Les ouvertures 41 sont de préférence régulièrement espacées entre elles selon x, par exemple d'une distance D ≤ 2d.

Après ouverture de la couche d'encapsulation 40a, une étape de gravure de la couche sacrificielle 30 sélectivement au dioxyde de silicium (SiO2) de la couche d'encapsulation 40a et du BOX 12 est réalisée au travers des ouvertures 41, de sorte à former des alvéoles sous-jacentes aux ouvertures 41 (figure 6).

Une alvéole correspond à une ouverture 41 au moins au début de la gravure. Les alvéoles sont de préférence centrées sur les ouvertures 41 correspondantes. Les alvéoles préservent avantageusement le matériau de la couche sacrificielle 30 au moins sur les flancs selon x.

Ces alvéoles peuvent avantageusement présenter un recouvrement entre elles de sorte à former la cavité 42 en fin de gravure.

Cette cavité 42 peut donc être éventuellement issue de plusieurs alvéoles agrégées.

Le positionnement des ouvertures 41 est choisi de sorte à ce que la cavité 42 issue des alvéoles sous-jacentes auxdites ouvertures 41 présente de préférence une section rectangulaire dans le plan xy après gravure.

La cavité 42 comprend une paroi inférieure formée par la face inférieure 424 en SiO2 du BOX 12. Elle comprend une paroi supérieure formée par la face 423 en SiO2 de la couche d'encapsulation 40a. Elle comprend en outre une première face latérale de germination 421 et une deuxième face latérale de germination 422.

La cavité 42 présente de préférence une largeur ws entre les première et deuxième faces latérales de germination 421, 422 de l'ordre de 3 µm, une longueur comprise entre 10 µm et 20 µm en fonction du nombre d'ouvertures 41 et une hauteur entre les parois inférieure et supérieure égale à la hauteur de la couche sacrificielle 30.

La largeur ws de la cavité 42 peut être inférieure à la largeur w de la première ouverture, de sorte à former une première marche 31 entre le BOX 12 et la première zone de contact 1, et une deuxième marche 32 entre le BOX 12 et la deuxième zone de contact 2.

La longueur de la cavité 42 peut être inférieure à la longueur de la première ouverture, de sorte à former une troisième marche entre le BOX 12 et le guide d'onde 301.

Selon une possibilité avantageuse, une couche d'oxyde 320 mince, telle qu'illustrée en vue de dessus à la figure 15, est formée entre le fuseau 302 ou le guide d'onde 301, et la zone active A, préalablement à la formation de la cavité 42.

Elle peut être formée à partir de procédés de gravure et/ou de lithographie, et de dépôt classiquement mis en oeuvre.

Elle présente de préférence une dimension selon x comprise entre 10nm et 100nm.

Elle permet avantageusement de former la cavité 42 sans former la troisième marche décrite plus haut. La cavité 42 s'étend dès lors selon x jusqu'à cette couche 320. La couche 320 peut ainsi former une paroi selon un plan yz de la cavité 42.

La cavité 42 est de préférence centrée par rapport à la première ouverture, au moins selon y, de façon à obtenir des première et deuxième marches 31, 32 présentant une largeur identique.

En particulier, la première ouverture peut présenter une largeur w = 3,2 µm, la cavité 42 peut présenter une largeur ws comprise entre 3 et 3,18 µm, et les première, deuxième et troisième marches 31, 32 peuvent présenter une largeur supérieure ou égale à10 nm et/ou inférieure ou égale à 100 nm.

La gravure est ici configurée pour produire des alvéoles et, par suite, la cavité 42 de forme et d'orientation contrôlées.

Selon z, les alvéoles s'étendent avantageusement sur toute la hauteur de la couche sacrificielle 30, entre une face inférieure 424 formée par une partie exposée du BOX 12 et une face supérieure 423 formée par une partie exposée de la couche d'encapsulation 40a.

Selon x et y, les alvéoles s'étendent de préférence selon une section sensiblement carrée dans le plan xy, les côtés du carré étant alignés selon x et y.

Dans le cas de la gravure de la couche sacrificielle 30 en Si, et plus généralement pour des matériaux présentant une structure cristallographique de type cubique faces centrées ou zinc blende, une telle forme carrée peut être avantageusement obtenue par une gravure anisotrope.

Une telle gravure anisotrope est notamment plus rapide dans les plans les plus denses du cristal.

Selon un mode de réalisation, la gravure, sèche ou humide, est configurée pour obtenir une vitesse de gravure dans les directions cristallographiques [110] et [1-10], supérieure d'au moins 25%, et de préférence d'au moins 35%, à la vitesse de gravure dans les directions [010] et [100].

Les directions des vitesses les plus grandes vont définir les diagonales d'un carré, aux tolérances de réalisation près. De ce fait, les côtés du carré sont orientés suivant la direction cristallographique [100] ou perpendiculairement à cette direction.

Les côtés de chaque alvéole selon x et y s'étendent donc préférentiellement respectivement selon les directions cristallographiques [100] et [010].

Dans le cas de la gravure de la couche sacrificielle 30 en Si, une gravure chimique utilisant un flux de vapeur d'acide chlorhydrique HCl à une température inférieure à 850°C, et de préférence inférieure à 820°C peut être avantageusement mise en oeuvre. La pression dans la chambre de gravure peut être comprise entre 10 Torr et la pression atmosphérique, et de préférence égale à 80 Torr. Le flux de HCl délivré peut être compris entre 1 slm et 25 slm (slm est l'acronyme de « standard liter per minute » en anglais, pour litres normaux par minute), et de préférence 15 slm. Un flux de H2 peut aussi être ajouté, par exemple entre quelques 1 slm et 40 slm de préférence 20 slm.

Ces conditions de gravure permettent de préférence de limiter le régime de gravure par réaction de surface, de façon à produire une gravure anisotrope de la couche sacrificielle 30 en Si.

Suivant une autre possibilité, la gravure est une gravure humide au travers des ouvertures 41. Dans le cas de la gravure de la couche sacrificielle 30 en Si, une solution de préférence aqueuse et comprenant de l'hydroxyde de potassium peut être utilisée. La gravure humide, appliquée à un espace confiné, permet d'obtenir des vitesses de gravure différentes selon les directions cristallographiques.

Lors de la gravure, les première et deuxième parois latérales sensiblement parallèles au plan zx de chacune des alvéoles progressent respectivement en direction des première et deuxième zones de contact 1, 2, tandis que les troisième et/ou quatrième parois latérales sensiblement parallèles au plan zy de deux alvéoles adjacentes progressent les unes vers les autres.

Le temps de gravure est de préférence choisi de manière à ce que les alvéoles issues de chaque ouverture 41 se rejoignent entre elles de sorte à former la cavité 42 en fin de gravure.

La cavité 42 en fin de gravure peut ainsi présenter une forme rectangulaire par réunion d'alvéoles de forme carrée selon la direction x.

La gravure est de préférence configurée pour que les première et deuxième faces latérales de germination 421, 422 selon zx de la cavité 42 forment respectivement les contremarches des première et deuxième marches 31, 32 des première et deuxième zones de contact 1, 2.

Selon une possibilité alternative, la gravure peut être arrêtée lorsque les première et deuxième faces latérales de germination 421, 422 selon zx de la cavité 42 se trouvent sensiblement à l'aplomb des première et deuxième faces latérales 411, 412 selon zx de la première ouverture, c'est-à-dire pour une largeur ws sensiblement égale à la largeur w.

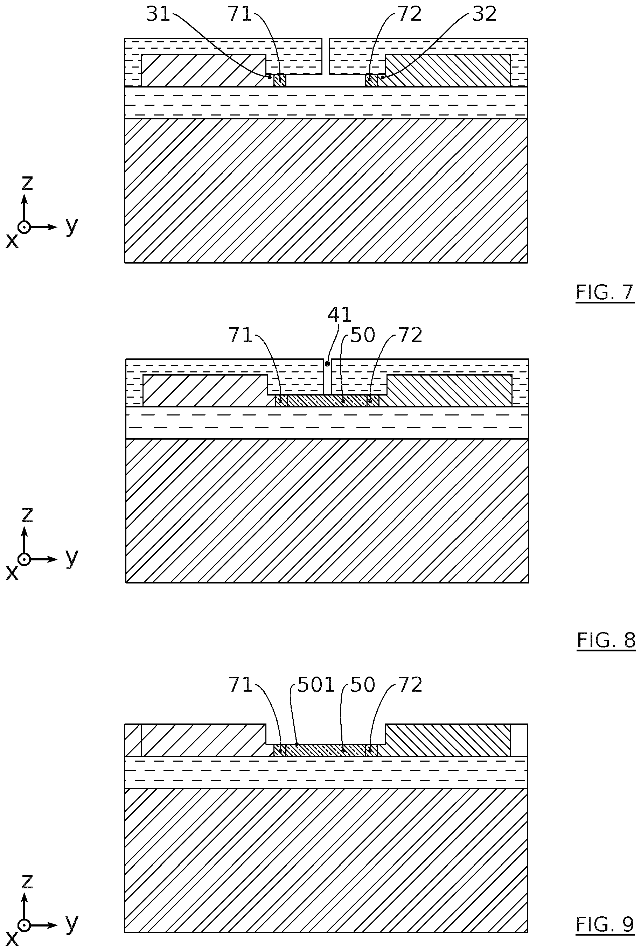

La cavité 42 est ensuite partiellement remplie par une première épitaxie latérale de germanium, de préférence de Ge-i, de sorte à former la ou les couches de germination 71, 72 (figure 7).

Le germanium est avantageusement épitaxié sur les parois latérales de germination 421, 422 à base de silicium de la cavité 42 par une première croissance épitaxiale latérale.

Cette première croissance par épitaxie latérale est guidée par les parois inférieure et supérieure à base de SiO2 de la cavité 42.

Elle peut être guidée par au moins une paroi selon yz à base de SiO2 de la cavité 42. Une telle paroi correspond par exemple à la partie exposée de la couche d'oxyde 320 mince après formation de la cavité 42.

Le front de croissance issu de la première paroi latérale de germination 421 se propage donc selon y en direction de la deuxième zone de contact 2 de façon bien contrôlée. De façon similaire, le front de croissance issu de la deuxième paroi latérale de germination 422 se propage selon y en direction de la première zone de contact 1 de façon bien contrôlée.

La première croissance latérale de Ge est de préférence réalisée à partir d'une chimie basée sur un précurseur germane GeH₄ en phase gazeuse. Un ajout d'acide chlorhydrique HCl en phase gazeuse peut avantageusement permettre d'éviter un trop fort encrassement des parois de la chambre du bâti d'épitaxie lors de l'épitaxie.

Cette épitaxie latérale de germanium est de préférence effectuée à une température « basse » de l'ordre de 400°C et à une pression de l'ordre de 100 Torr pendant une durée de quelques minutes. Une telle température « basse » permet de limiter l'apparition de défauts d'épitaxie dans la couche de germination 71, 72.

Selon une possibilité, l'épitaxie latérale de germanium peut se faire en deux temps, d'abord à la température « basse » puis à une température « haute » de l'ordre de 600°C à 700°C et à une pression de l'ordre de 20 Torr. Une telle température « haute » permet de bénéficier de vitesses de croissance élevées. Une telle température « haute » permet également de répartir plus uniformément les dislocations présentes au sein du germanium épitaxié grâce à une plus grande mobilité desdites dislocations, et de minimiser potentiellement leur densité par recombinaison/annihilation de dislocations.

La ou les couches de germination 71, 72 ainsi formées présente une épaisseur égale à l'épaisseur résiduelle e, comprise entre 10 nm et 50 nm.

Une telle épaisseur permet de limiter l'apparition de défauts structuraux dans cette couche de germination 71, 72 en Ge-i.

La figure 19 montre une couche de Ge-i accolée latéralement à une couche de Si. Cette couche de Ge-i présente une épaisseur de 16 nm, et a été obtenue par épitaxie latérale entre deux couches d'oxyde formant les parois inférieure et supérieure selon l'invention.

La couche de Ge-i ainsi obtenue est exempte de défauts structuraux. En particulier, elle est exempte de dislocations, notamment de dislocations traversantes.

Par ailleurs, l'interface entre la couche de Si et la couche de Ge-i est plane et bien définie.

La première croissance latérale de Ge est configurée pour obtenir une ou des couches de germination 71, 72 présentant une largeur supérieure ou égale à10 nm et/ou inférieure ou égale à 100 nm.

A l'issue de cette première croissance latérale, la cavité 42 comprend la paroi inférieure formée par la face inférieure 424 en SiO2 du BOX 12, la paroi supérieure formée par la face 423 en SiO2 de la couche d'encapsulation 40a, une première face latérale de base 431 et une deuxième face latérale de base 432 (figure 7).

La cavité 42 est ensuite totalement remplie par une deuxième épitaxie latérale de germanium-étain, de préférence de GeSn-i, de sorte à former la couche de base 50 (figure 8).

L'alliage de germanium-étain est avantageusement épitaxié sur les parois latérales de base 431, 432 à base de germanium de la cavité 42 par une deuxième croissance épitaxiale latérale.

Les couches de germination 71, 72 en Ge-i exemptes de défauts structuraux (en particulier de dislocations, notamment de dislocations traversantes) forment avantageusement des germes pour cette deuxième croissance latérale.

La qualité cristalline de cette couche de base 50 en GeSn peut ainsi être optimisée.

Cette deuxième épitaxie latérale de GeSn est de préférence effectuée à une température comprise entre 300°C et 400°C. Une telle température permet de limiter l'apparition de défauts d'épitaxie dans la couche de base 50.

Cette deuxième épitaxie latérale de GeSn est de préférence réalisée à partir d'une chimie basée sur des précurseurs GeH₄ ou Ge₂H₆ et SnCl₄ en phase gazeuse. Ces précurseurs sont de préférence dilués dans du dihydrogène H₂, pour des rapports de flux F(Ge₂H₆)/F(H₂) = 7.92×10⁻⁴ et F(SnCl₄)/F(H₂) = 4.12×10⁻⁵ par exemple.

Cette deuxième épitaxie latérale de GeSn peut être effectuée pour une pression comprise entre 20 Torr et 100 Torr.

Cette deuxième croissance par épitaxie latérale est guidée par les parois inférieure et supérieure à base de SiO2 de la cavité 42.

Cette deuxième croissance latérale est donc configurée pour former la couche de base 50 présentant une épaisseur égale à l'épaisseur résiduelle e, comprise entre 10 nm et 50 nm.

Une telle épaisseur permet de limiter l'apparition de défauts structuraux dans la couche de base 50 en GeSn. En particulier, la croissance peut être pseudomorphe, c'est-à-dire que les contraintes d'épitaxie (liées notamment à la différence de paramètres de maille entre le Ge et le GeSn) peuvent être relâchées élastiquement pendant la croissance.

La contrainte résiduelle en compression dans cette couche de base 50 en GeSn peut ainsi être diminuée.

Avantageusement, une telle couche de base 50 en GeSn peut présenter une concentration d'étain comprise entre 8% et 12%, par exemple de l'ordre de 10%.

Le front de croissance de GeSn issu de la première paroi latérale de base 431 en Ge se propage donc selon y en direction de la deuxième zone de contact 2 de façon bien contrôlée. De façon similaire, le front de croissance de GeSn issu de la deuxième paroi latérale de base 432 en Ge se propage selon y en direction de la première zone de contact 1 de façon bien contrôlée.

Ces fronts de croissance de GeSn se rejoignent dans une zone médiane sensiblement à l'aplomb des ouvertures 41. Cette zone médiane peut présenter des défauts structuraux. Dans la suite, la zone active de la source de lumière est donc avantageusement décalée par rapport à cette zone médiane.

L'épitaxie latérale de GeSn est poursuivie jusqu'à ce que le GeSn couvre toute la face inférieure 424 en SiO2 du BOX 12.

Elle peut être poursuivie jusqu'à ce que le GeSn remplisse au moins partiellement les ouvertures 41.

La couche de base 50 ainsi formée assure une continuité électrique entre les première et deuxième zones de contact 1, 2 et/ou entre les première et deuxième marches 31, 32.

La couche d'encapsulation 40a est ensuite retirée, au moins partiellement, de manière à exposer la face supérieure 501 de la couche de base 50 (figure 9). Une gravure humide du SiO2 sélectivement au Si, au Ge et au GeSn peut être mise en oeuvre de façon à retirer cette couche d'encapsulation 40a. Une telle gravure, par exemple à base d'une solution d'acide fluorhydrique HF, est connue de l'homme du métier.

De façon optionnelle, une étape de planarisation comprenant par exemple une gravure anisotrope de la couche de base 50 peut être effectuée de sorte à retirer une excroissance du GeSn au niveau des ouvertures 41 et/ou de la zone médiane.

Cette étape de planarisation est configurée de manière à améliorer la planéité de la face supérieure 501 de la couche de base 50.

Une autre étape de préparation de surface, par exemple un nettoyage, de la face supérieure 501, peut également être effectuée, préalablement à la croissance épitaxiale verticale de GeSn.

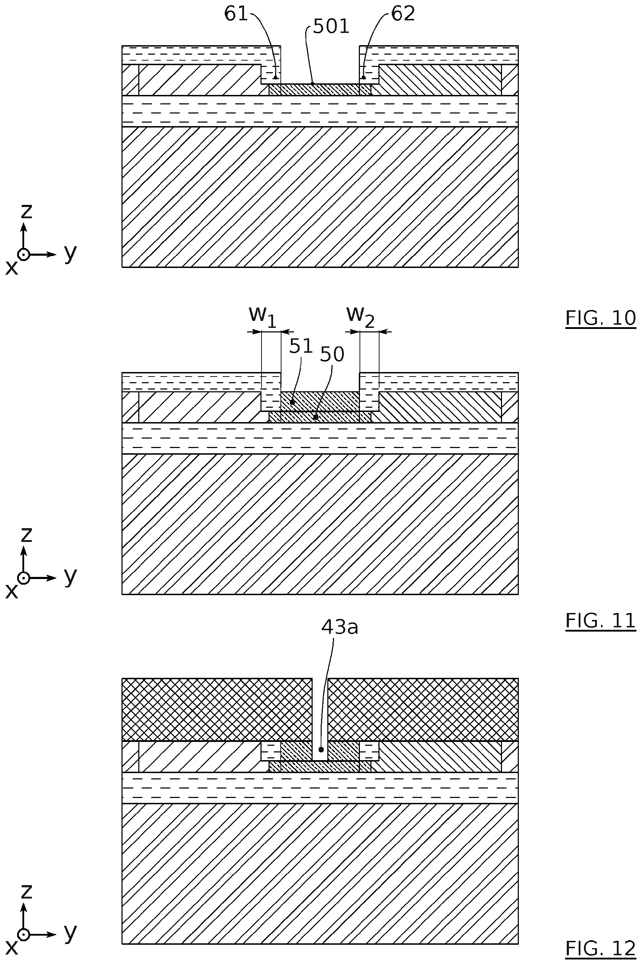

Une étape de masquage des faces à base de Si peut être avantageusement effectuée, de sorte à exposer uniquement la face supérieure 501 de la couche de base 50 en GeSn (figure 10).

Les première et deuxième zones de contact 1, 2, les flancs de la première ouverture, les première, deuxième et troisième marches 31, 32, et/ou les couches de germination 71, 72 peuvent ainsi être couverts par une couche en un matériau diélectrique, par exemple du SiO2 ou un nitrure de silicium (SiN) peu contraint.

Des couches latérales 61, 62 en SiO2 ou en SiN sont ainsi avantageusement formées.

La première couche latérale 61 couvrant la première face latérale 411 peut présenter une largeur w1 comprise entre 10 nm et 100 nm.

La deuxième couche latérale 62 couvrant la deuxième face latérale 412 peut présenter une largeur w2 comprise entre 10 nm et 100 nm.

Une troisième couche latérale couvrant la face de sortie du fuseau 302 ou du guide d'onde 301 peut présenter une dimension selon x comprise entre 10 nm et 100 nm. Elle peut reposer sur la troisième marche. Elle peut alternativement correspondre à la couche d'oxyde 320 mince.

Ces première, deuxième et troisième couches latérales 61, 62 permettent avantageusement de guider la croissance épitaxiale verticale de GeSn (figure 11).

Les première et deuxième couches latérales 61, 62 permettent en outre d'améliorer le confinement optique d'une onde lumineuse dans la zone active A. Ces première et deuxième couches latérales 61, 62 reposant sur les première et deuxième marches 31, 32 et/ou sur les couches de germination 71, 72 induisent à la fois un confinement optique par contraste d'indices de réfraction, et un confinement optique géométrique.

En particulier, des première et deuxième couches latérales 61, 62 en SiO2 présentent une grande différence d'indice de réfraction avec le GeSn de la zone active A. Cela augmente le confinement optique dit par contraste d'indices.

Les couches de germination 71, 72 forment dans le plan zy un profil transverse en « T inversé » ou « en arête ». Cela peut favoriser le confinement optique géométrique.

La troisième couche latérale est de préférence configurée pour optimiser le couplage optique entre le fuseau 302 ou le guide d'onde 301 et le GeSn de la zone active A, c'est-à-dire pour optimiser la transmission d'une onde lumineuse se propageant depuis la zone active A vers le guide d'onde 301 selon un mode optique donné.

En particulier, pour une dimension selon x inférieure ou égale à 20 nm, une troisième couche latérale en SiO2 permet de transmettre un mode gaussien d'une onde lumineuse présentant une longueur d'onde comprise entre 1.6 µm et 4 µm, par exemple de l'ordre de 2.5 µm ou 3 µm, quasiment sans pertes optiques. Pour une dimension selon x supérieure ou égale à 40 nm, une troisième couche latérale en SiN peu contraint, présentant un indice de réfraction supérieur au SiO2, permet de limiter les pertes optiques dans la transmission d'un mode gaussien d'une onde lumineuse présentant une telle longueur d'onde.

La croissance par épitaxie verticale du GeSn se fait à partir de la face supérieure 501 de la couche de base 50 en GeSn. Cette couche de base 50 forme donc un germe pour la croissance de la couche de structure 51.

Les couches latérales 61, 62 évitent une croissance parasite de GeSn sur les flancs de la première ouverture et/ou sur les couches de germination 71, 72 en Ge.

Le front de croissance issu de cette face supérieure 501 se propage donc selon z de façon bien contrôlée.

La couche de structure 51 ainsi formée présente une qualité cristalline optimisée.

A l'issue de l'épitaxie verticale, le front de croissance correspond à la surface supérieure de la couche de structure 51.

Cette surface supérieure peut se situer soit en-dessous d'un plan comprenant les surfaces des zones de contact 1, 2, soit sensiblement dans ce plan, en affleurement des surfaces des zones de contact 1, 2, soit au-dessus de ce plan, en dépassement des surfaces des zones de contact 1, 2.

Dans ce dernier cas, un polissage ultérieur peut être effectué pour niveler les surfaces des zones de contact 1, 2 et la surface supérieure de la couche de structure 51. Ce nivellement est cependant optionnel.

L'épitaxie verticale du GeSn est de préférence effectuée à une température comprise entre 300°C et 400°C.

Selon une possibilité, l'épitaxie verticale de GeSn peut se faire en deux temps, d'abord à une température de l'ordre de 300°C, puis à une température de l'ordre de 400°C. Cela permet de limiter l'apparition de défauts d'épitaxie dans la couche de structure 51 au début de l'homoépitaxie, puis de bénéficier de vitesses de croissance suffisamment élevées compatibles avec la formation d'une couche de structure 51 de forte épaisseur, par exemple de l'ordre de 250 nm ou plus.

La gravure du top Si 11 pour former la première ouverture et la cavité 42, les première et deuxième croissances latérales et la croissance verticale peuvent se faire avantageusement dans un même bâti, de sorte à éviter une oxydation des faces latérales de germination 421, 422, des faces latérales de base 431, 432 et de la face supérieure 501.

Une gravure localisée du GeSn au niveau de la zone médiane est ensuite avantageusement effectuée. Elle est notamment configurée pour retirer une partie des défauts de structure du GeSn potentiellement apparus à la fin de la deuxième croissance latérale.

Cette gravure localisée permet de former une fente 43a dans la couche de structure 51 (figure 12).

Cette fente 43a est principalement dirigée selon x et permet de séparer un premier tronçon 51a en GeSn et un deuxième tronçon 51b en GeSn.

Cette fente 43a ne débouche pas sur le BOX 12. Un ruban 52 de GeSn présentant une épaisseur de l'ordre de 50 nm est conservé entre le BOX 12 et la fente 43a de façon à assurer une continuité électrique entre les première et deuxième zones de contact 1, 2 pour l'injection électrique des porteurs dans la zone active A.

Au moins une implantation est de préférence effectuée au niveau du deuxième tronçon 51b, du ruban 52, et de la couche de germination 72 de façon à les doper de type n+. Le GeSn peut être dopé n+ de façon efficace avec du phosphore. Un tel dopage est par exemple décrit dans le document « S. Prucnal et al. 2018, Semicond. Sci. Technol., 33 (2018) 065008 ». Ce dopage, éventuellement réalisé par plusieurs implantations, vise à obtenir une zone de type n+ continue entre la deuxième zone de contact 2 et le premier tronçon 51a formant au moins en partie la zone active A, tel qu'illustré aux figures 13 et 14. Cette zone de type n+ permet ainsi d'injecter des porteurs depuis la zone de contact 2 vers la zone active A.

L'injection électrique des porteurs dans la zone active A se fait de préférence depuis la première zone de contact 1 par l'intermédiaire de la première marche 31 et de la couche de germination 71, et depuis la deuxième zone de contact 2 par l'intermédiaire de la deuxième marche 32, de la couche de germination 72 dopée, du deuxième tronçon 51b dopé et le ruban 52 dopé (figures 14 et 15).

Les première et deuxième marches 31, 32 de cette source de lumière constituent des zones d'injection de porteurs. Pour compenser une faible épaisseur de ces zones d'injection de porteurs, le dopage des première et deuxième marches 31, 32 peut être augmenté, par exemple par une étape d'implantation à une dose plus élevée après avoir exposé la couche sacrificielle 30. Une dose supérieure ou égale à 5.10¹⁹ cm⁻³ peut convenir.

Afin de former une cavité optique pour l'amplification laser au niveau de la zone active A, la fente 43a est de préférence remplie par un matériau diélectrique, de préférence du SiO2.

Un polissage mécano-chimique (CMP) est de préférence effectué afin d'exposer la face supérieure de la zone active A.

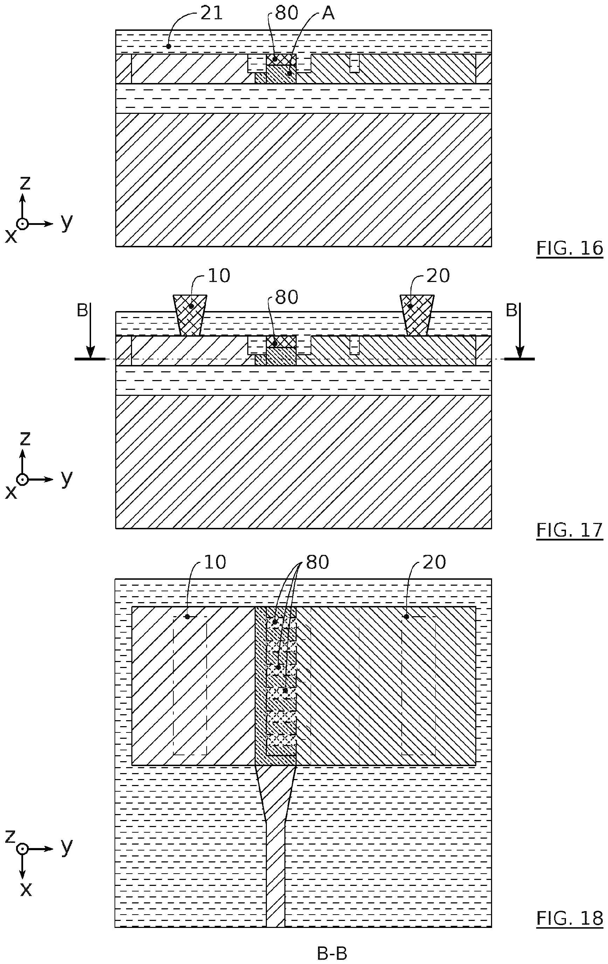

Des miroirs de Bragg distribués 80 DBR (acronyme anglais de « Distributed Bragg Reflectors ») peuvent ensuite être formés sur la face supérieure de la zone active A (figure 16).

Ces miroirs de Bragg distribués 80 DBR permettent avantageusement de confiner le ou les modes optiques d'émission dans la zone active A. Une cavité optique est ainsi avantageusement formée. Cette cavité optique peut être résonnante à la longueur d'onde d'émission du laser. De façon connue en soi, les miroirs de Bragg distribués 80 peuvent être complétés ou remplacés par des structures de retour distribuées 80 ou DFB (acronyme anglais de « Distributed FeedBack »).

La cavité optique peut être formée selon d'autres architectures, par exemple de type coin cube, Fabry-Pérot.

Les avantages liés à ces différentes structures ou architectures sont connus de l'homme du métier. L'architecture de la cavité optique peut dès lors être choisie en fonction de ces avantages (fonctionnement monomode, laser accordable, fort courant d'injection pour le pompage électrique etc.).

Une couche d'encapsulation 21, de préférence en SiO2, est ensuite formée de manière à couvrir les DBR 80 et/ou les zones de contact 1, 2, comme illustré aux figures 16 et 18.

Les étapes suivantes peuvent être des étapes classiques de formation des contacts métalliques, comprenant notamment la formation de vias traversants au niveau des première et deuxième zones de contact 1, 2, le dépôt des contacts métalliques 10, 20 dans les vias (figure 17) et d'éventuels recuits thermiques rapides (par exemple de type RTA de l'acronyme anglais « Rapid Thermal Annealing », ou de type « flash lamp », ou encore de type « laser annealing » selon les terminologies anglo-saxonnes) pour l'activation des contacts 10, 20.

Une source laser GeSn à injection latérale est ainsi avantageusement obtenue (figures 17 et 18).

Une telle source laser permet notamment d'émettre un flux lumineux se propageant principalement selon x selon un mode optique fondamental TE00, tel qu'illustré en figure 20 par le résultat de simulations obtenues pour cette source.

D'autres modes de réalisation sont décrits dans la suite.

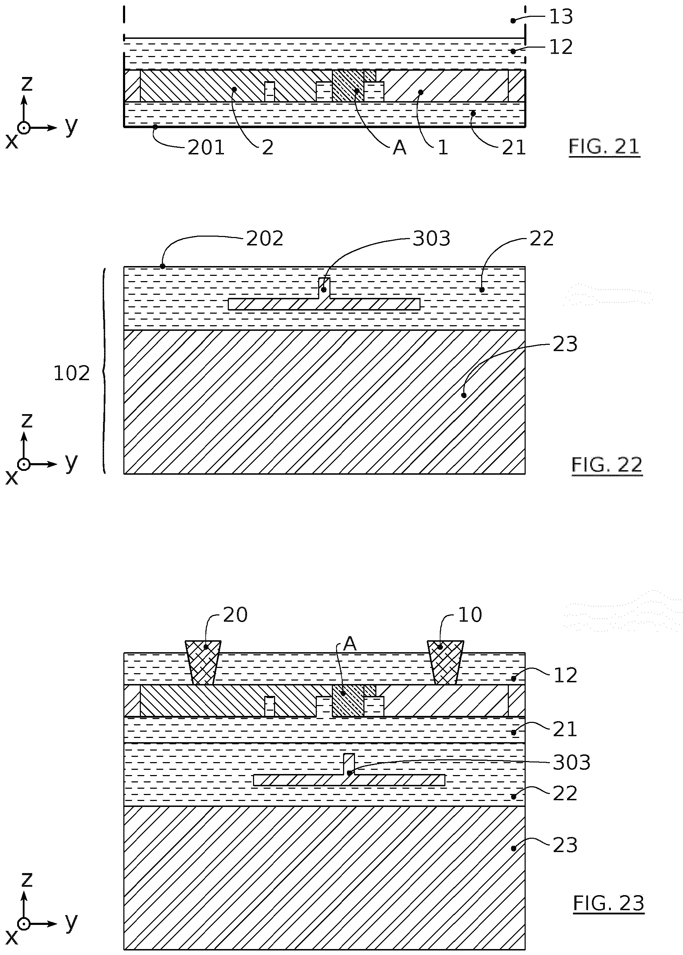

Seules les caractéristiques de ces modes de réalisations distinctes du premier mode de réalisation sont décrites ci-après, les autres caractéristiques non décrites étant réputées identiques à celles du premier mode de réalisation décrit ci-dessus en référence aux figures 1 à 18. En particulier, un autre mode de réalisation de l'invention est une source de lumière à injection latérale, par exemple une source laser ou une LED, à base de phosphure d'indium InP. Dans ce cas, le GeSn de la zone active A (couche de base 50 + couche de structure 51) est remplacé par l'InP (figure 11). La zone active A de cette source de lumière à base d'InP relaxé présente avantageusement une efficacité d'émission améliorée. Les modes de réalisation suivants peuvent également alternativement comprendre de l'InP à la place du GeSn. Un deuxième mode de réalisation du procédé selon l'invention va maintenant être décrit en référence aux figures 21 à 23.

La source de lumière obtenue par ce deuxième mode de réalisation est une source laser GeSn issue d'un premier substrat 101 et reportée sur un deuxième substrat 102. Les premières étapes de ce deuxième mode de réalisation sont des étapes communes avec celles du premier mode de réalisation illustrées aux figures 1 à 16. Elles consistent essentiellement à former les première et deuxième zones de contact 1, 2, définir le premier motif 300 et de préférence uniquement le premier motif 300, former la zone active A en GeSn et les DBR 80, et encapsuler le tout par la couche d'encapsulation 21 (figure 21).

Ces étapes sont réalisées selon les mêmes conditions que celles exposées précédemment dans le premier mode de réalisation de l'invention.

La couche d'encapsulation 21 est une couche d'oxyde. Cette couche d'oxyde 21 présente de préférence une épaisseur uniforme, comprise entre quelques dizaines de nanomètres et quelques centaines de nanomètres, et une face libre 201.

Le deuxième substrat 102 peut être par exemple un substrat de silicium 23 comprenant éventuellement des dispositifs optoélectroniques ou microélectroniques sur une face dite face active. Ce deuxième substrat 102 peut également comprendre des matériaux III-V et/ou des dispositifs de type photonique sur silicium sur sa face active.

Le deuxième substrat 102 peut notamment comprendre un guide d'onde 303 en arête, de préférence en silicium, isolé dans une couche 22 en un matériau diélectrique, de préférence du SiO2.

Le guide d'onde 303 se trouve de préférence au sein de cette couche 22 (figure 22). Cette couche d'oxyde 22 peut présenter une épaisseur comprise entre quelques centaines de nanomètres et quelques microns.

La somme des épaisseurs de la couche d'oxyde 21 et de la couche d'oxyde 22 est de préférence comprise entre 800 nm et 2800 nm.

La couche d'oxyde 22 présente une face libre 202.

Le guide d'onde 303 en arête présente de préférence une arête en saillie tournée vers la face libre 202, à une distance comprise entre 10 nm et 500 nm de ladite face libre 202.

Un collage direct entre les premier et deuxième substrats 101, 102 est de préférence effectué.

Une étape de préparation de surface des faces libres 201, 202 des premier et deuxième substrats 101, 102, comprenant par exemple un nettoyage et une hydrolyse, est de préférence réalisée. Le nettoyage peut être réalisé par exemple dans un bain d'eau désionisée enrichie en ozone. L'hydrolyse peut être réalisée par exemple dans une solution de peroxyde d'ammonium (APM pour l'acronyme anglais « Ammonium Peroxide Mixture ») à 70°C.

Après préparation des surfaces, la face libre 201 de l'oxyde 21 du premier substrat 101 est mise en contact avec la face libre 202 de l'oxyde 22 du deuxième substrat 102, à température et pression ambiantes.

L'arête du guide d'onde 303 en arête est de préférence orientée selon x et alignée avec la zone active A. Elle peut être centrée selon y sur la zone active A, ou décalée de quelques centaines de nanomètres par rapport au centre de la zone active A. La distance selon z séparant la zone active A et l'arête du guide d'onde 303 peut être comprise entre 50 nm et 300 nm, de façon à former un couplage évanescent entre le guide d'onde 303 et la zone active A.

Selon une possibilité, le guide d'onde 303 peut être structuré sur tout ou partie de sa longueur pour réaliser respectivement une cavité optique DFB ou une cavité optique DBR autour de la zone active A.

La structuration du guide d'onde 303 permet avantageusement d'éviter une structuration de la zone active A pour former la cavité optique. Les surfaces en GeSn de la zone active A sont ainsi préservées. Les pertes optiques de surface par recombinaisons non-radiatives sont ainsi limitées.

Un recuit à 400°C pendant deux heures peut ensuite être effectué de manière à finaliser le collage direct par adhésion moléculaire entre les oxydes 21, 22 (figure 23).

Ce deuxième mode de réalisation permet d'isoler partiellement la source laser de la structure de guidage (le guide d'onde 303).

Le Si bulk 13 du premier substrat 101 peut ensuite être retiré, par exemple par rognage et abrasion sur au moins 95 % de son épaisseur initiale puis par gravure sélective dans une solution à base d'hydroxyde de tetramethylammonium (TMAH) ou d'hydroxyde de potassium (KOH), de sorte à exposer le BOX 12. Une telle gravure peut présenter un ratio de sélectivité Si/SiO2 de l'ordre de 5000/1.

Cette possibilité permet d'obtenir en surface une couche d'oxyde d'épaisseur très bien contrôlée formée par le BOX 12 exposé.

Des vias traversants au niveau des première et deuxième zones de contact 1, 2 de la source laser GeSn peuvent ensuite être formés, et des contacts métalliques 10, 20 peuvent ensuite être déposés au niveau des vias puis activés (figure 23).

Avantageusement, les contacts métalliques 10, 20 présentent des surfaces métalliques en affleurement des première et deuxième zones de contact 1, 2, dans un plan définissant une bordure supérieure de la zone active A. Le transport de charges et/ou le confinement optique d'une telle source laser GeSn à injection latérale peut ainsi être amélioré. L'intégration d'une telle source laser par des étapes technologies classiques d'interconnexions (lignes métal et vias dans les technologies BEOL, acronyme de « Back End Of Line ») est ainsi facilitée.

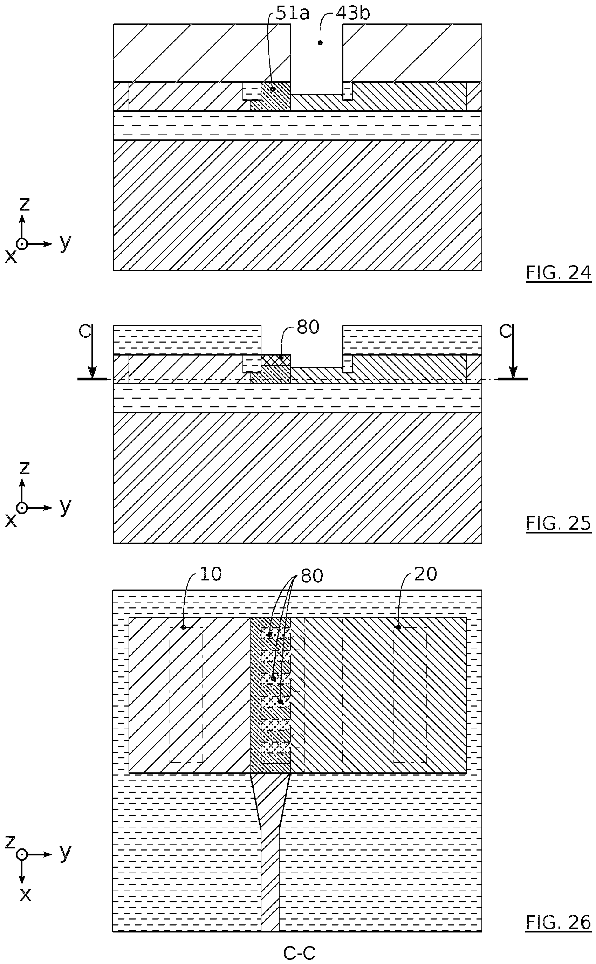

Un troisième mode de réalisation du procédé selon l'invention va maintenant être décrit en référence aux figures 24 à 26.

La source de lumière obtenue par ce troisième mode de réalisation est une source laser GeSn à injection latérale.

Les premières étapes de ce deuxième mode de réalisation sont des étapes communes avec celles du premier mode de réalisation illustrées aux figures 1 à 11. Elles consistent essentiellement à former les première et deuxième zones de contact 1, 2, définir les premier et deuxième motifs 300, 301, et faire croître les couches de base 50 et de structure 51 en GeSn.

Ces étapes sont de préférence réalisées selon les mêmes conditions que celles exposées précédemment dans le premier mode de réalisation de l'invention.

Une gravure localisée du GeSn sur environ la moitié de la largeur de la couche de structure 51 est ensuite avantageusement effectuée. Elle est notamment configurée pour retirer une partie des défauts de structure du GeSn potentiellement apparus à la fin de la deuxième croissance latérale.

Comparativement au premier mode de réalisation, cette gravure localisée permet de former une fente 43b élargie par rapport à la fente 43a séparant les premier et deuxième tronçons 51a, 51b.

En particulier, cette fente 43b permet de former le premier tronçon 51a en GeSn, et d'éliminer partiellement le deuxième tronçon 51b (figure 24).

La profondeur de gravure est choisie de manière à conserver un ruban de GeSn présentant une épaisseur environ égale à l'épaisseur de la couche de germination, par exemple de l'ordre de 50 nm, de façon à assurer une continuité électrique entre les première et deuxième zones de contact 1, 2 pour l'injection électrique des porteurs dans la zone active A.

Au moins une implantation est de préférence effectuée au niveau de ce ruban de façon à doper le GeSn de type n+.

Les DBR 80 peuvent ensuite être formés (figures 25 et 26) et la source encapsulée.

L'injection électrique latérale et/ou le confinement optique latéral peuvent ainsi être améliorés dans ce troisième mode de réalisation.

En particulier, le flux lumineux émis par cette source laser est avantageusement confiné dans le premier tronçon 51a en GeSn. Cela permet avantageusement d'obtenir une propagation du flux lumineux principalement selon x selon un mode optique fondamental TE00, tel qu'illustré en figure 27 par le résultat de simulations obtenues pour cette source.

Ce mode optique fondamental TE00 est quasi-gaussien et présente de faibles pertes optiques. Un tel mode optique, obtenu par exemple par la source laser selon ce troisième mode de réalisation, peut avantageusement être utilisé pour l'encodage optique d'informations.

Selon un quatrième mode de réalisation illustré par les figures 28 à 30, les deux tronçons 51a et 51b de la zone active A en GeSn peuvent être conservés de façon à réaliser deux cavités optiques séparées par la fente 43a (figures 28, 29).

Dans ce cas, la formation des DBR 80 se fait dans la partie supérieure de chaque tronçon 51a, 51b, tel que détaillé sur la figure 29.

Une telle source laser comprend dès lors deux régions de gain dans la zone active A. Elle permet notamment d'obtenir une propagation du flux lumineux principalement selon x selon un mode optique TE01, tel qu'illustré en figure 31 par le résultat de simulations obtenues pour cette source.

Afin de collecter la lumière émise dans la zone active A et de transmettre ce mode TE01 au guide d'onde 301, un fuseau 302 élargi par rapport aux modes de réalisation précédents peut être préalablement défini, tel qu'illustré en figure 30.

Un couplage évanescent, par exemple avec un guide d'onde en arête sous-jacent présentant deux arêtes en saillie, peut également être envisagé.

Une telle source laser configurée pour émettre un flux lumineux se propageant selon un mode optique TE01 peut être couplée à un convertisseur de mode 400, de façon à convertir ce mode TE01 en un mode TE00.

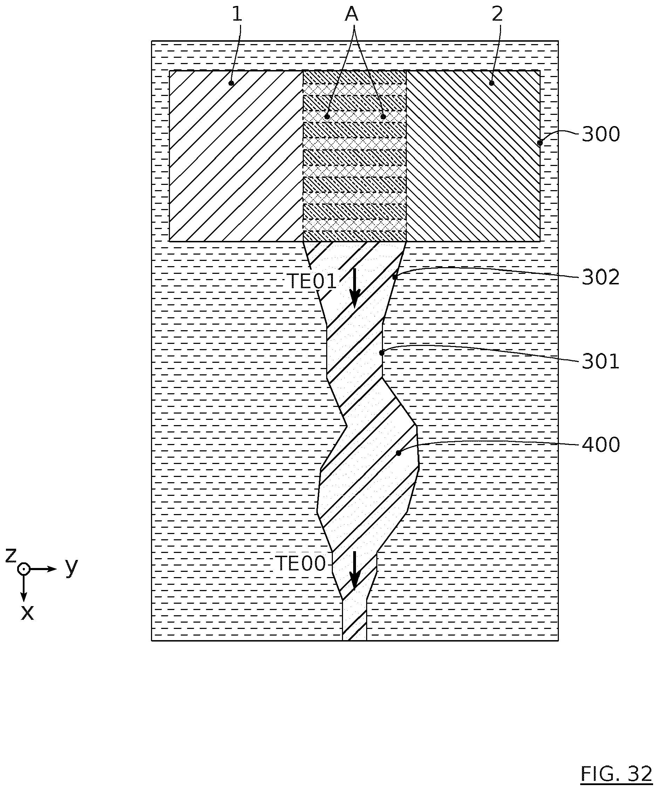

Un tel convertisseur 400, comprenant par exemple différentes sections désaxées et élargies par rapport à la direction x de propagation du flux lumineux, est représenté à la figure 32.

Il peut fonctionner pour une longueur d'onde comprise entre 1,6 µm et 4 µm.

Il est de préférence configuré pour convertir le mode TE01 en un mode gaussien TE00 avec une efficacité de conversion supérieure ou égale à 95%, par exemple de l'ordre de 97%, voire de l'ordre de 99%.

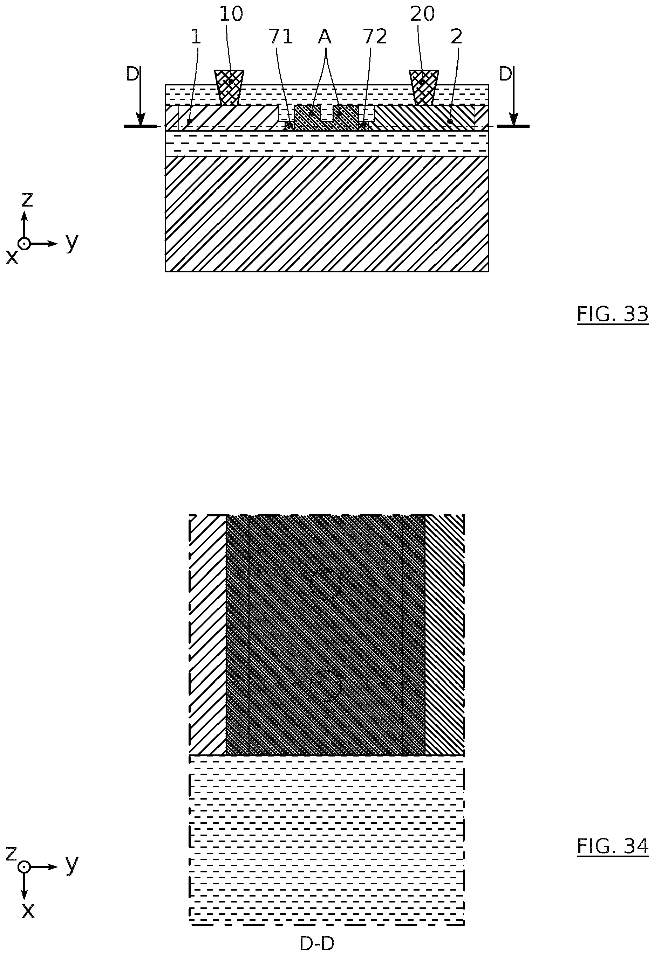

Selon un cinquième mode de réalisation illustré par les figures 33 et 34, les deux tronçons 51a et 51b de la zone active A en GeSn peuvent être conservés et encapsulés sans former de DBR.

L'injection de porteurs dans la zone active A permet dès lors d'émettre une lumière non cohérente.

La source de lumière obtenue par ce cinquième mode de réalisation est une source de type LED.

De façon optionnelle, un ou des guides d'onde peuvent également être couplé à cette source, par exemple par l'intermédiaire d'un ou plusieurs fuseaux, de façon à collecter au moins partiellement et à guider la lumière diffuse émise par cette source non directionnelle.

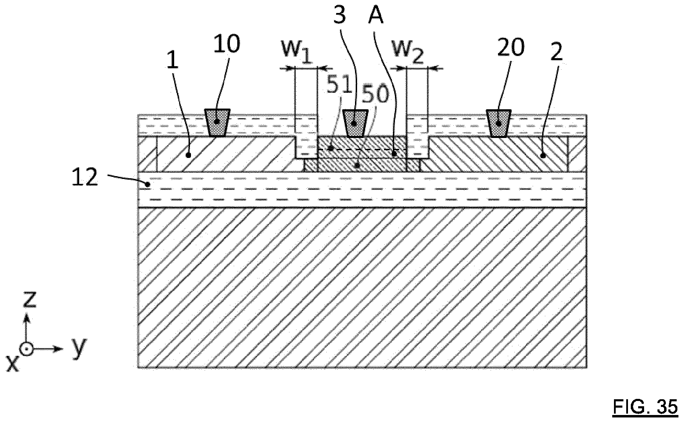

Selon un sixième mode de réalisation illustré à la figure 35, les zones de contact 1, 2 peuvent être en un même matériau et/ou présenter un même type de dopage, par exemple Si-n, et la zone centrale comprenant les couches 50, 51 peut présenter un type de dopage complémentaire, par exemple GeSn-p ou InP-p. En particulier, la zone centrale peut se présenter sous forme d'un empilement selon z comprenant, en partant du BOX 12, les régions suivantes : une région n+ formée dans la couche de base 50, par exemple lnP-n+, une zone active A formée dans la couche de structure 51, par exemple InP-i avec des puits quantiques InGaAs, une région p+ formée dans la couche de structure 51, par exemple InP-p+.

Les zones de contact 1, 2 sont dès lors reliées à des contacts n 10, 20 et la région centrale est reliée à un contact p 3. Cette architecture de source de lumière permet d'améliorer la distribution des lignes de courant électrique au sein de la zone active A.

L'invention n'est pas limitée aux modes de réalisations précédemment décrits et s'étend à tous les modes de réalisation couverts par les revendications.

Par exemple, la couche de structure 51 à base de GeSn peut comprendre d'autres couches, par exemple en SiGeSn, de manière à former des hétérostructures ou des puits quantiques à base de GeSn durant l'homoépitaxie. De tels puits quantiques améliorent le confinement de porteurs dans la zone active A. Alternativement, la couche de structure 51 à base d'InP peut comprendre des puits quantiques à base d'InGaAs.

## Revendications

1. Procédé de réalisation d'une source de lumière comprenant une première zone de contact (1), une deuxième zone de contact (2) et une zone active (A) juxtaposées parallèlement à une première direction (x) d'un plan basal, ladite zone active (A) étant située entre les première et deuxième zones de contact (1, 2) selon une deuxième direction (y) du plan basal, ledit procédé comprenant les étapes suivantes :
▪ Fournir un premier substrat (101) comprenant un empilement selon une troisième direction (z) normale au plan basal d'une première couche (11) à base d'un premier matériau en silicium ou en silicium-germanium sur une deuxième couche (12) à base d'un deuxième matériau différant du premier matériau, le deuxième matériau étant un matériau diélectrique, ladite première couche (11) étant au contact de la deuxième couche (12),
▪ Former, au niveau de la première couche (11), la première zone de contact (1),
▪ Former, au niveau de la première couche (11), la deuxième zone de contact (2),
▪ Former, au niveau de la première couche (11), la zone active (A), ledit procédé étant **caractérisé en ce que** la zone active (A) comprend une couche de base (50), ladite couche de base (50) étant formée avec les étapes successives suivantes :
▪ Retirer le premier matériau dans la zone active sur toute l'épaisseur de la première couche de façon à exposer d'une part une portion d'une face inférieure (424) à base du deuxième matériau, et d'autre part au moins une face à base du premier matériau normale au plan basal, dite face latérale de germination (421, 422), présentant un bord au contact de ladite face inférieure (424) exposée,
▪ Former une couche de germination (71, 72) en un troisième matériau, le troisième matériau étant du germanium, avec une première croissance épitaxiale, dite première croissance latérale, dudit troisième matériau à partir de l'au moins une face latérale de germination (421, 422), ladite première croissance étant principalement dirigée selon la deuxième direction (y) et au moins partiellement guidée par la portion exposée de la face inférieure (424), la couche de germination recouvrant uniquement partiellement la portion exposée de la face inférieure (424) de sorte que la couche de germination (71, 72) présente au moins une face à base du troisième matériau normale au plan basal, dite face latérale de base,
▪ Former la couche de base (50) en un quatrième matériau en un alliage de germanium-étain ou de phosphure d'indium InP, différant du troisième matériau, avec une deuxième croissance épitaxiale, dite deuxième croissance latérale, dudit quatrième matériau à partir de l'au moins une face latérale de base, ladite croissance étant principalement dirigée selon la deuxième direction (y) et au moins partiellement guidée par la portion exposée de la face inférieure (424), de sorte que la portion exposée de la face inférieure (424) soit entièrement recouverte.

2. Procédé selon la revendication précédente dans lequel la zone active (A) comprend une couche de structure (51) en un cinquième matériau à base dudit quatrième matériau, ladite couche de structure étant formée avec une croissance épitaxiale, dite croissance verticale, du cinquième matériau selon la troisième direction à partir d'une portion exposée d'une face supérieure (501) de la couche de base (50).

3. Procédé selon la revendication précédente, dans lequel la formation de la couche de structure comprend en outre, avant la croissance verticale, l'étape suivante :
▪ Former au moins une couche latérale (61, 62) présentant des parois latérales sensiblement normales au plan basal en un matériau différant du premier matériau, ladite au moins une couche latérale (61, 62) prenant appui sur une face parallèle au plan basal comprenant la face supérieure (501) de la couche de base (50),
de sorte que la croissance verticale permettant de former la couche de structure (51) soit au moins partiellement guidée par lesdites parois latérales.

4. Procédé selon l'une quelconque des revendications précédentes, dans lequel le retrait du premier matériau dans la zone active sur toute l'épaisseur de la première couche comprend les étapes successives suivantes :
a. Retirer le premier matériau de la première couche en conservant une couche sacrificielle (30) à base du premier matériau sur la deuxième couche, ladite couche sacrificielle présentant une épaisseur résiduelle e selon la troisième direction et une largeur w selon la deuxième direction,
b. Encapsuler la couche sacrificielle (30) par une couche d'encapsulation (40) en un matériau d'encapsulation différant du premier matériau,
c. Former au moins une ouverture (41) au travers de la couche d'encapsulation (40) de sorte à exposer une zone de la couche sacrificielle,
d. Former une cavité (42) de largeur ws en retirant le premier matériau sur toute l'épaisseur résiduelle de la couche sacrificielle (30) au travers de l'au moins une ouverture (41), de façon à exposer la face inférieure (424) à base du deuxième matériau, l'au moins une face latérale de germination (421) et une face (423) de la couche d'encapsulation, la cavité (42) comprenant ladite au moins une face latérale de germination (421), une paroi inférieure formée par ladite face inférieure (424) et une paroi supérieure parallèle au plan basal et à base du matériau d'encapsulation formée par ladite face (423) de la couche d'encapsulation (40),
de sorte que la première croissance latérale permettant de former la couche de germination et la deuxième croissance latérale permettant de former la couche de base (50) soient au moins partiellement guidées par lesdites parois inférieure et supérieure, la couche de germination et la couche de base (50) présentant des épaisseurs égales à l'épaisseur résiduelle e.

5. Procédé selon la revendication précédente seule, dans lequel la largeur ws de la cavité (42) est inférieure à la largeur w de la couche sacrificielle (30), de sorte que la couche sacrificielle (30) forme au moins une marche (31) entre la deuxième couche (12) et la première couche (11).

6. Procédé selon l'une quelconque des revendications précédentes, dans lequel les premier, troisième et quatrième matériaux présentent chacun une structure cristallographique de type cubique, et dans lequel la première direction (x) correspond à une orientation cristallographique de type [100], la deuxième direction (y) correspond à une orientation cristallographique de type [010], et la troisième direction (z) correspond à une orientation cristallographique de type [001].

7. Procédé selon l'une quelconque des revendications précédentes, dans lequel la deuxième croissance latérale présente un premier front de croissance à partir d'une première face latérale de base et un deuxième front de croissance à partir d'une deuxième face latérale de base, lesdits premier et deuxième fronts de croissance se rejoignant au niveau d'une zone de jonction pour former la couche de base (50), et dans lequel la couche de base (50) comprend ladite zone de jonction.

8. Procédé selon la revendication précédente, dans lequel la couche de base est partiellement gravée selon la troisième direction au niveau de la zone de jonction.

9. Procédé selon la revendication 2 en combinaison avec l'une des deux revendications précédentes dans lequel la couche de structure est partiellement gravée selon la troisième direction au niveau d'une zone en prolongement de la zone de jonction.

10. Procédé selon l'une quelconque des revendications précédentes, dans lequel le premier matériau est du silicium.

11. Procédé selon l'une quelconque des revendications précédentes, dans lequel la couche de base présente une épaisseur supérieure ou égale à 10 nm et/ou inférieure ou égale à 50 nm.

12. Source de lumière comprenant une première zone de contact (1) et une deuxième zone de contact (2) formées dans une première couche (11) à base d'un premier matériau en silicium ou en silicium-germanium, et une zone active (A), lesdites première et deuxième zones de contact (1, 2) et la zone active (A) étant juxtaposées de sorte à s'étendre parallèlement suivant une première direction (x), ladite zone active (A) étant située entre les première et deuxième zones de contact (1, 2) selon une deuxième direction (y), la première couche (11) étant au contact d'une deuxième couche (12) à base d'un deuxième matériau différant du premier matériau, le deuxième matériau étant un matériau diélectrique, selon une troisième direction (z) perpendiculaire aux première et deuxième directions (x, y), la source de lumière étant **caractérisée en ce qu'**elle comprend une couche de germination en un troisième matériau différant des premier et deuxième matériaux, le troisième matériau étant du germanium, et directement au contact du deuxième matériau de la deuxième couche (12), ladite couche de germination étant intercalée selon la deuxième direction entre la zone active (A) et l'une au moins parmi les première et deuxième zones de contact (1, 2), et **en ce que** la zone active (A) est formée suivant une épaisseur de la première couche (11) et comprend un quatrième matériau en un alliage de germanium-étain, à gap direct, relaxé mécaniquement et différant du troisième matériau, ce quatrième matériau étant directement au contact du deuxième matériau de la deuxième couche (12) et du troisième matériau de la couche de germination.

13. Source de lumière selon la revendication précédente, dans laquelle l'une au moins parmi les première et deuxième zones de contact (1, 2) présente une marche en regard de l'autre parmi les première et deuxième zones de contact (1, 2), ladite marche prenant appui sur la deuxième couche (12) et étant située entre la première couche (11) et la zone active (A).

14. Source de lumière selon l'une quelconque des deux revendications précédentes, dans laquelle la zone active (A) est configurée pour émettre un flux lumineux se propageant principalement selon la première direction (x) selon un mode optique de propagation de type TE01, dit mode TE01, comprenant en outre un convertisseur de mode (302, 301, 400) directement couplé à la zone active (A), ledit convertisseur de mode (302, 301, 400) étant configuré pour convertir ledit mode TE01 en un mode optique de propagation de type TE00, dit mode TE00, de préférence avec une efficacité de conversion supérieure ou égale à 95%, et de préférence avec une efficacité de conversion supérieure ou égale à 97%.

## Patentansprüche

1. Verfahren zur Erstellung einer Lichtquelle, eine erste Kontaktzone (1), eine zweite Kontaktzone (2) und eine Aktivzone (A) umfassend, die parallel zu einer ersten Richtung (x) einer Basisebene nebeneinander liegen, wobei die Aktivzone (A) zwischen der ersten und der zweiten Kontaktzone (1, 2) in einer zweiten Richtung (y) der Basisebene angeordnet ist, wobei das Verfahren die folgenden Schritte umfasst:
- Bereitstellen eines ersten Substrats (101), das einen Stapel in einer dritten Richtung (z) senkrecht zur Basisebene einer ersten Schicht (11) umfasst, die auf einem ersten Material aus Silizium oder Siliziumgermanium basiert, auf einer zweiten Schicht (12), die auf einem zweiten Material basiert, das sich vom ersten Material unterscheidet, wobei das zweite Material ein dielektrisches Material ist, wobei die erste Schicht (11) in Kontakt mit der zweiten Schicht (12) steht,
- Bilden, im Bereich der ersten Schicht (11), der ersten Kontaktzone (1),
- Bilden, im Bereich der ersten Schicht (11), der zweiten Kontaktzone (2),
- Bilden, im Bereich der ersten Schicht (11), der Aktivzone (A), wobei das Verfahren **dadurch gekennzeichnet ist, dass** die Aktivzone (A) eine Basisschicht (50) umfasst, wobei die Basisschicht (50) mit folgenden aufeinanderfolgenden Schritten gebildet wird:
- Entfernen des ersten Materials in der Aktivzone über der gesamten Dicke der ersten Schicht, so dass einerseits ein Abschnitt einer unteren Fläche (424) freigelegt wird, die auf dem zweiten Material basiert, und andererseits mindestens eine Fläche, die auf dem ersten Material basiert, senkrecht zur Basisebene, laterale Keimfläche (421, 422) genannt, die eine Kante in Kontakt mit der unteren freigelegten Fläche (424) aufweist,
- Bilden einer Keimschicht (71, 72) aus einem dritten Material, wobei das dritte Material Germanium ist, mit einem ersten epitaktischen Wachstum, erstes laterales Wachstum genannt, des dritten Materials von der mindestens einen lateralen Keimfläche (421, 422) ausgehend, wobei das erste Wachstum hauptsächlich in die zweite Richtung (y) gerichtet ist, und mindestens teilweise vom freigelegten Abschnitt der unteren Fläche (424) geleitet wird, wobei die Keimschicht den freigelegten Abschnitt der unteren Fläche (424) nur teilweise bedeckt, so dass die Keimschicht (71, 72) mindestens eine Fläche aufweist, die auf dem dritten Material basiert, senkrecht zur Basisebene, laterale Basisfläche genannt,
- Bilden der Basisschicht (50) aus einem vierten Material aus einer Legierung aus Germanium-Zinn oder Indiumphosphid InP, die sich vom dritten Material unterscheidet, mit einem zweiten epitaktischen Wachstum, zweites laterales Wachstum genannt, des vierten Materials, von der mindestens einen laterale Basisfläche ausgehend, wobei das Wachstum hauptsächlich in die zweite Richtung (y) gerichtet ist und mindestens teilweise von dem freigelegten Abschnitt der unteren Fläche (424) geleitet wird, so dass der freigelegte Abschnitt der unteren Fläche (424) vollständig bedeckt wird.

2. Verfahren nach dem vorhergehenden Anspruch, wobei die Aktivzone (A) eine Strukturschicht (51) aus einem fünften Material umfasst, das auf dem vierten Material basiert, wobei die Strukturschicht mit einem epitaktischen Wachstum, vertikales Wachstum genannt, des fünften Materials gebildet wird, in der dritten Richtung von einem freigelegten Abschnitt einer oberen Fläche (501) der Basisschicht (50) ausgehend.

3. Verfahren nach dem vorhergehenden Anspruch, wobei die Bildung der Strukturschicht ferner vor dem vertikalen Wachstum den folgenden Schritt umfasst:
- Bilden mindestens einer lateralen Schicht (61, 62), die Lateralwände im Wesentlichen senkrecht zur Basisebene aufweist, aus einem Material, das sich vom ersten Material unterscheidet, wobei die mindestens eine laterale Schicht (61, 62) auf einer zur Basisebene parallelen Fläche ruht, die die obere Fläche (501) der Basisschicht (50) umfasst,
so dass das vertikale Wachstum, das die Bildung der Strukturschicht (51) ermöglicht, mindestens teilweise von den Lateralwänden geleitet wird.

4. Verfahren nach einem der vorhergehenden Ansprüche, wobei die Schwindung des ersten Materials in der Aktivzone über die gesamte Dicke der ersten Schicht die folgenden aufeinanderfolgenden Schritte umfasst:
a. Entfernen des ersten Materials aus der ersten Schicht unter Beibehaltung einer Opferschicht (30), die auf dem ersten Material der zweiten Schicht basiert, wobei die Opferschicht eine Restdicke e in der dritten Richtung aufweist und eine Breite w in der zweiten Richtung,
b. Verkapseln der Opferschicht (30) durch eine Verkapselungsschicht (40), aus einem Verkapselungsmaterial, das sich vom ersten Material unterscheidet,
c. Bilden mindestens einer Öffnung (41) durch die Verkapselungsschicht (40), so dass eine Zone der Opferschicht freigelegt wird,
d. Bilden eines Hohlraums (42) mit der Breite ws, indem das erste Material über die gesamte Restdicke der Opferschicht (30) durch die mindestens eine Öffnung (41) entfernt wird, um die untere Fläche (424), die auf dem zweiten Material basiert, die mindestens eine laterale Keimfläche (421) und eine Fläche (423) der Verkapselungsschicht freizulegen, wobei der Hohlraum (42) die mindestens eine laterale Keimfläche (421) umfasst, eine untere Wand, die von der unteren Fläche (424) gebildet wird, und eine obere Wand, die parallel zur Basisebene ist, und auf dem Verkapselungsmaterial basiert, das durch die Fläche (423) der Verkapselungsschicht (40) gebildet wird,
so dass das erste laterale Wachstum, das die Bildung der Keimschicht ermöglicht, und das zweite laterale Wachstum, das die Bildung der Basisschicht (50) ermöglicht, mindestens teilweise von der unteren und oberen Wand geleitet werden, wobei die Keimschicht und die Basisschicht (50) Dicken aufweisen, die der Restdicke e entsprechen.

5. Verfahren nur nach dem vorhergehenden Anspruch, wobei die Breite ws des Hohlraums (42) kleiner ist als die Breite w der Opferschicht (30), so dass die Opferschicht (30) mindestens eine Stufe (31) zwischen der zweiten Schicht (12) und der ersten Schicht (11) bildet.

6. Verfahren nach einem der vorhergehenden Ansprüche, wobei das erste, dritte und vierte Material jeweils eine kristallographische Struktur vom kubischen Typ aufweisen, und wobei die erste Richtung (x) einer kristallographischen Orientierung vom Typ [100] entspricht, die zweite Richtung (y) einer kristallographischen Orientierung vom Typ [010] entspricht und die dritte Richtung (z) einer kristallographischen Orientierung vom Typ [001] entspricht.

7. Verfahren nach einem der vorhergehenden Ansprüche, wobei das zweite laterale Wachstum eine erste Wachstumsfront aufweist, ausgehend von einer ersten lateralen Basisfläche und eine zweite Wachstumsfront, ausgehend von einer zweiten lateralen Basisfläche, wobei sich die erste und die zweite Wachstumsfront im Bereich einer Verbindungszone treffen, um die Basisschicht (50) zu bilden, und wobei die Basisschicht (50) die Verbindungszone umfasst.

8. Verfahren nach dem vorhergehenden Anspruch, wobei die Basisschicht teilweise in der dritten Richtung im Bereich der Verbindungszone geätzt wird.

9. Verfahren nach Anspruch 2 in Kombination mit einem der zwei vorhergehenden Ansprüche, wobei die Strukturschicht in der dritten Richtung im Bereich einer Zone teilweise geätzt wird, die sich von der Verbindungszone aus verlängert.

10. Verfahren nach einem der vorhergehenden Ansprüche, wobei das erste Material Silizium ist.

11. Verfahren nach einem der vorhergehenden Ansprüche, wobei die Basisschicht eine Dicke von mehr als oder gleich 10 nm aufweist und/oder weniger als oder gleich 50 nm.

12. Lichtquelle, die eine erste Kontaktzone (1) und eine zweite Kontaktzone (2) umfasst, die in einer ersten Schicht (11) gebildet sind, die auf einem ersten Material aus Silizium oder Siliziumgermanium basiert, und eine Aktivzone (A), wobei die erste und die zweite Kontaktzone (1, 2) und die Aktivzone (A) nebeneinander liegen, so dass sie sich parallel in einer ersten Richtung (x) erstrecken, wobei die Aktivzone (A) zwischen der ersten und der zweiten Kontaktzone (1, 2) in einer zweiten Richtung (y) angeordnet ist, und die erste Schicht (11) in Kontakt mit einer zweiten Schicht (12) ist, die auf einem zweiten Material basiert, das sich vom ersten Material unterscheidet, wobei das zweite Material ein dielektrisches Material ist, in einer dritten Richtung (z) perpendikular zur ersten und zweiten Richtung (x, y), wobei die Lichtquelle **dadurch gekennzeichnet ist, dass** sie eine Keimschicht aus einem dritten Material umfasst, das sich vom ersten und zweiten Material unterscheidet, wobei das dritte Material Germanium ist, und in direktem Kontakt mit dem zweiten Material der zweiten Schicht (12) ist, wobei die Keimschicht in der zweiten Richtung zwischen der Aktivzone (A) und mindestens einer von der ersten und der zweiten Kontaktzone (1, 2) eingeschoben ist, und dass die Aktivzone (A) gemäß einer Dicke der ersten Schicht (11) gebildet ist, und ein viertes Material einer Legierung aus Germanium-Zinn umfasst, mit direktem Übergang, das mechanisch entspannt ist und sich vom dritten Material unterscheidet, wobei dieses vierte Material in direktem Kontakt mit dem zweiten Material der zweiten Schicht (12) und dem dritten Material der Keimschicht steht.

13. Lichtquelle nach dem vorhergehenden Anspruch, wobei mindestens eine der ersten und zweiten Kontaktzonen (1, 2) eine Stufe aufweist, die der anderen zugewandt ist, zwischen der ersten und zweiten Kontaktzone (1, 2), wobei die Stufe auf der zweiten Schicht (12) ruht, und zwischen der ersten Schicht (11) und der Aktivzone (A) angeordnet ist.

14. Lichtquelle nach einem der zwei vorhergehenden Ansprüche, wobei die Aktivzone (A) konfiguriert ist, um einen Lichtstrom zu emittieren, der sich hauptsächlich in der ersten Richtung (x) ausbreitet gemäß einem optischen Ausbreitungsmodus vom Typ TE01, TE01-Modus genannt, ferner einen Moduswandler (302, 301, 400) umfassend, der direkt mit der Aktivzone (A) gekoppelt ist, wobei der Moduswandler (302, 301, 400) konfiguriert ist, um den TE01-Modus in einen optischen Ausbreitungsmodus vom Typ TE00, TE00-Modus genannt, umzuwandeln, vorzugsweise mit einem Umwandlungswirkungsgrad größer oder gleich 95 % und vorzugsweise mit einem Umwandlungswirkungsgrad größer oder gleich 97 %.

## Claims

1. A method for producing a light source comprising a first contact area (1), a second contact area (2) and an active area (A) juxtaposed parallel to a first direction (x) of a basal plan, said active area (A) being located between the first and second contact areas (1, 2) in a second direction (y) of the basal plan, said method comprising the following steps:
- Providing a first substrate (101) comprising a stack in the third direction (z) normal to the basal plane of a first layer (11) based on a first silicon or silicon-germanium material on a second layer (12) based on a second material different from the first material, the second material being a dielectric material, said first layer (11) being in contact with the second layer (12),
- Forming, at the first layer (11), the first contact area (1),
- Forming, at the first layer (11), the second contact area (2),
- Forming, at the first layer (11), the active area (A), said method being **characterised in that** the active area (A) comprises a base layer (50), said base layer (50) being formed with the following successive steps:
- Removing the first material in the active area over the entire thickness of the first layer so as to expose, on the one hand, a portion of a lower face (424) based on the second material, and on the other hand, at least one face based on the first material normal to the basal plane, called the lateral face of germination (421, 422), having an edge in contact with said lower exposed face (424),
- Forming a germination layer (71, 72) from a third material, the third material being germanium, with first epitaxial growth, called first lateral growth, of said third material from the at least one lateral face of germination (421, 422), said first growth being mainly directed in the second direction (y) and at least partially guided by the exposed portion of the lower face (424), the germination layer covering only partially the exposed portion of the lower face (424) so that the germination layer (71, 72) has at least one face based on the third material normal to the basal plane, called the base lateral face,
- Forming the base layer (50) from a fourth material of a germanium-tin or indium phosphide InP alloy, differing from the third material, with a second epitaxial growth, called the second lateral growth, of the fourth material from the at least one base lateral face, said growth being mainly directed in the second direction (y) and at least partially guided by the exposed portion of the lower face (424), so that the exposed portion of the lower face (424) is fully covered.

2. The method according to the preceding claim wherein the active area (A) comprises a structure layer (51) made of a fifth material based on said fourth material, said structure layer being formed with epitaxial growth, called vertical growth, of the fifth material in the third direction from an exposed portion of an upper face (501) of the base layer (50).

3. The method according to the preceding claim, wherein the formation of the structure layer further comprises, before the vertical growth, the following step:
- Forming at least one lateral layer (61, 62) with lateral walls substantially normal to the basal plane from a material differing from the first material, said at least one lateral layer (61, 62) bearing on a face parallel to the basal plane comprising the upper face (501) of the base layer (50),
so that the vertical growth allowing to form the structure layer (51) is at least partially guided by said side walls.

4. The method according to any one of the preceding claims, wherein the removal of the first material in the active area over the entire thickness of the first layer comprises the following successive steps:
a. Removing the first material from the first layer while retaining a sacrificial layer (30) based on the first material on the second layer, said sacrificial layer having a residual thickness e in the third direction and a width W in the second direction,
b. Encapsulating the sacrificial layer (30) by an encapsulation layer (40) made of an encapsulation material different from the first material,
c. Forming at least one opening (41) through the encapsulation layer (40) so as to expose an area of the sacrificial layer,
d. Forming a cavity (42) of width ws by removing the first material on the entire residual thickness of the sacrificial layer (30) through the at least one opening (41), so as to expose the lower face (424) based on the second material, the at least one lateral face of germination (421) and one face (423) of the encapsulation layer, the cavity (42) comprising said at least one lateral face of germination (421), a lower wall formed by said lower face (424) and an upper wall parallel to the basal plane and based on the encapsulation material formed by said face (423) of the encapsulation layer (40),
so that the first lateral growth allowing to form the germination layer and the second lateral growth allowing to form the base layer (50) are at least partially guided by the lower and upper walls, the germination layer and the base layer (50) having thicknesses equal to the residual thickness e.

5. The method according to the preceding claim alone, wherein the width w of the cavity (42) is less than the width ws of the sacrificial layer (30), so that the sacrificial layer (30) forms at least one step (31) between the second layer (12) and the first layer (11).

6. The method according to any one of the preceding claims, wherein the first, third and fourth materials each have a crystallographic structure of the cubic type, and wherein the first direction (x) corresponds to a crystallographic orientation of type [100], The second direction (y) corresponds to a crystallographic orientation of the type [010], and the third direction (z) corresponds to a crystallographic orientation of the type [001].

7. The method according to any one of the preceding claims, wherein the second lateral growth has a first growth front from a first base lateral face and a second growth front from a second base lateral face, said first and second growth fronts meet at a junction area to form the base layer (50), and wherein the base layer (50) comprises said junction area.

8. The method according to the preceding claim, wherein the base layer is partially etched in the third direction at the junction area.

9. The method according to claim 2 as combined with one of the two preceding claims wherein the structure layer is partially etched in the third direction at an extension zone of the junction area.

10. The method according to any one of the preceding claims, wherein the first material is silicon.

11. The method according to any one of the preceding claims, wherein the base layer has a thickness greater than or equal to 10 nm and/or less than or equal to 50 nm.

12. A light source comprising a first contact area (1) and a second contact area (2) formed in a first layer (11) based on a first silicon or silicon-germanium material, and an active area (A), said first and second contact areas (1, 2) and the active area (A) being juxtaposed so as to extend in parallel in the first direction (x), said active area (A) being located between the first and second contact areas (1, 2) in a second direction (y), the first layer (11) being in contact with a second layer (12) based on a second material different from the first material, the second material being a dielectric material, in a third direction (z) perpendicular to the first and second directions (x, y), the light source being **characterised in that** it comprises a germination layer made of a third material different from the first and second materials, the third material being germanium, and directly in contact with the second material of the second layer (12), said germination layer being interposed in the second direction between the active area (A) and at least one of the first and second contact areas (1, 2) , and **in that** the active area (A) is formed according to a thickness of the first layer (11) and comprises a fourth material made of a germanium-tin alloy, with direct bandgap, mechanically relaxed and differs from the third material, this fourth material being directly in contact with the second material of the second layer (12) and the third material of the germination layer.

13. The light source according to the preceding claim, wherein at least one of the first and second contact areas (1, 2) has a step opposite the other among the first and second contact areas (1, 2), said step bearing on the second layer (12) and being located between the first layer (11) and the active area (A).

14. The light source according to any one of the two preceding claims, wherein the active area (A) is configured to emit a light flux propagating mainly in the first direction (x) according to an optical mode of propagation of TE01 type, called TE01 mode, further comprising a mode converter (302, 301, 400) directly coupled with the active area (A), said mode converter (302, 301, 400) being configured to convert said TE01 mode into an optical propagation mode of the TE00 type, called TE00 mode, preferably with conversion efficiency greater than or equal to 95%, and preferably with conversion efficiency greater than or equal to 97%.
